# EUROPEAN PATENT APPLICATION

(11) **EP 4 615 175 A1**
(43) Date of publication of application: **10.09.2025**
(21) Application number: 23920094.2
(22) Date of filing: 27.07.2023
(51) Int. Cl.: H05K 5/00, H05K 5/03, H04N 5/655, G09F 9/30

(54) **DISPLAY DEVICE**

(30) Priority: 30.01.2023 KR 20230011908
(71) Applicant: Samsung Electronics Co., Ltd., Suwon-si, Gyeonggi-do 16677 (KR)
(72) Inventor: KIM, Seungjae, Suwon-si Gyeonggi-do 16677 (KR); KIM, Jisu, Suwon-si Gyeonggi-do 16677 (KR); OH, Pilyong, Suwon-si Gyeonggi-do 16677 (KR); LEE, Kwangjae, Suwon-si Gyeonggi-do 16677 (KR); CHOI, Hyunyong, Suwon-si Gyeonggi-do 16677 (KR)
(74) Representative: Appleyard Lees IP LLP
(86) International application number: PCT/KR2023/010911
(87) International publication number: WO 2024/162544

(57) **Abstract**

A display device is disclosed. The disclosed display device comprises: a display panel; a rear chassis for supporting the display panel; electronic equipment which is adjacent to the rear chassis, and which has an insertion hole; a stud coupled to the rear chassis through first coupling force so as to protrude from the rear chassis; and a fastening member which can be coupled to the stud through second coupling force by passing through the insertion hole of the electronic equipment so that the electronic equipment is mounted on the rear chassis or which can be separated from the stud, the fastening member including a fastening member head having a diameter greater than that of the insertion hole, wherein the second coupling force is less than the first coupling force so that the coupling of the stud to the rear chassis is maintained, while mounting of the electronic equipment is released from the rear chassis by separating the fastening member form the stud.

## Description

### [TECHNICAL FIELD]

The present disclosure relates to a display device, and more particularly, to a display device including electronic equipment and a rear chassis on which the electronic equipment is mounted.

### [BACKGROUND ART]

A display device is a kind of output device for visually displaying images and data information, such as characters, figures, etc.

The display device includes a display panel on which visual information is displayed. Behind the display panel, a rear chassis for supporting the display panel is provided. Generally, electronic equipment for performing various functions of the display device is arranged behind the rear chassis, and a rear cover covers the electronic equipment.

To couple the electronic equipment to the rear chassis, studs and coupling members are used. The studs are coupled to the rear chassis. The electronic equipment is positioned adjacent to the studs. The coupling members are coupled with the studs to prevent the electronic equipment from being separated from the studs.

The electronic equipment needs to be separated from the rear chassis for reasons such as electronic equipment replacement. In this case, while the coupling members are separated from the studs, the studs need to be prevented from being separated from the rear chassis.

### [DISCLOSURE]

### [TECHNICAL PROBLEM]

It is an aspect of the present disclosure to provide a display device capable of preventing a stud from being separated from a rear chassis while a coupling member is separated from the stud.

It is an aspect of the present disclosure to provide a display device in which a friction force between a stud and a rear chassis is greater than a friction force between the stud and a coupling member.

A display device according to a concept of the present disclosure may include a display panel, a rear chassis supporting the display panel, electronic equipment being adjacent to the rear chassis and including an insertion hole, a stud coupled to the rear chassis with a first coupling force toprotrude from the rear chassis, and a coupling member coupled to the stud with a second coupling force by penetrating the insertion hole of the electronic equipment to install the electronic equipment on the rear chassis, the coupling member being decouplable from the stud and including a coupling member head having a greater diameter than the insertion hole, wherein the second coupling force may be weaker than the first coupling force such that, while the electronic equipment is decoupled from the rear chassis by separating the coupling member from the stud, coupling of the stud and the rear chassis is maintained.

A display device according to a concept of the present disclosure may include a display panel including a plurality of display modules, a rear chassis supporting the display panel, a gap prevention sheet positioned between the plurality of display modules and the rear chassis, wherein a thermal expansion coefficient of the gap prevention sheet may have a value that is closer to a thermal expansion coefficient of the plurality of display modules than a thermal expansion coefficient of the rear chassis to prevent formation of a gap between the plurality of display modules, a deformation prevention sheet positioned between the gap prevention sheet and the rear chassis, wherein a thermal expansion coefficient of the deformation prevention sheet may be smaller than the thermal expansion coefficient of the gap prevention sheet and the thermal expansion coefficient of the rear chassis to prevent deformation of the rear chassis from being transferred to the gap prevention sheet, electronic equipment being adjacent to the rear chassis and including an insertion hole, a stud of which at least a part is positioned by penetrating the insertion hole, the stud including a chassis coupling portion inserted in the rear chassis and having a stud thread, and a coupling member coupled to the stud to install the electronic equipment on the rear chassis, the coupling member including a stud coupling portion having a coupling member thread capable of being inserted into the stud, wherein, while the stud coupling portion is separated from the stud, coupling of the stud and the rear chassis may be maintained.

A display device according to a concept of the present disclosure may include a display panel including a plurality of display modules being adjacent to each other, a rear chassis supporting the display panel, the rear chassis including a first metal layer positioned toward the display panel, a second metal layer positioned to be opposite to the first metal layer, and a resin layer positioned between the first metal layer and the second meal layer, electronic equipment being adjacent to the rear chassis and including an insertion hole, a stud coupled to the rear chassis and positioned by penetrating the insertion hole, and a coupling member coupled to the stud, wherein the stud may include a chassis coupling portion inserted into the rear chassis along an extension direction of the stud and having a stud thread,
the coupling member may include a stud coupling portion having a coupling member thread capable of being inserted into the stud along an extension direction of the coupling member, and an angle of the coupling member thread with respect to the extension direction of the coupling member may be smaller than an angle of the stud thread with respect to the extension direction of the stud.

### [DESCRIPTION OF DRAWINGS]

FIG. 1 is a perspective view of a display device according to an embodiment of the present disclosure.
FIG. 2 is a cross-sectional view showing a cross section cut around light-emitting devices shown in FIG. 1.
FIG. 3 is an exploded perspective view of the display device shown in FIG. 1.
FIG. 4 is a rear exploded perspective view showing some of disassembled parts of the display device shown in FIG. 1.
FIG. 5 is a rear perspective view showing components related to a rear chassis and electronic equipment shown in FIG. 3.
FIG. 6 is a rear exploded perspective view showing the components related to the rear chassis and the electronic equipment shown in FIG. 5.
FIG. 7 is a cross-sectional view of the components related to the rear chassis and the electronic equipment shown in FIG. 5, taken along line VII-VII'.
FIG. 8 is an exploded cross-sectional view of a part A of FIG. 7.
FIG. 9 is an exploded perspective view showing a stud nut, a stud, and a coupling member shown in FIG. 8.
FIG. 10 is a side view showing a coupled state of the stud and the coupling member shown in FIG. 9.
FIG. 11 is an exploded cross-sectional view of the stud nut and the stud shown in FIG. 9.
FIG. 12 is a cross-sectional perspective view showing decoupling of a coupling member in the components related to the rear chassis and the electronic equipment shown in FIG. 7.
FIG. 13 is a cross-sectional perspective view showing a decoupled state of the coupling member shown in FIG. 12.
FIG. 14 is a cross-sectional perspective view showing the electronic equipment shown in FIG. 13, decoupled from a stud.
FIG. 15 is a cross-sectional perspective view showing a state of the rear chassis shown in FIG. 5 before a stud nut is coupled to the rear chassis.
FIG. 16 is a cross-sectional perspective view showing a processed state of the rear chassis shown in FIG. 15 to couple the stud nut to the rear chassis.
FIG. 17 is a cross-sectional perspective view showing a state in which a stud is coupled to the stud nut coupled to the rear chassis shown in FIG. 16.
FIG. 18 is a cross-sectional view showing a part of a display device according to an embodiment of the present disclosure.
FIG. 19 is a cross-sectional view showing a part of a display device according to an embodiment of the present disclosure.
FIG. 20 is a cross-sectional view showing a part of a display device according to an embodiment of the present disclosure.
FIG. 21 is a cross-sectional view showing a part of a display device according to an embodiment of the present disclosure.
FIG. 22 is a cross-sectional view showing a part of a display device according to an embodiment of the present disclosure.
FIG. 23 is a cross-sectional view showing a part of a display device according to an embodiment of the present disclosure.

### [MODES OF THE INVENTION]

Various embodiments of the present document and terms used therein are not intended to limit the technical features described in this document to specific embodiments, and should be understood to include various modifications, equivalents, or substitutes of the corresponding embodiments.

In connection with the description of the drawings, similar reference numerals may be used for similar or related components.

The singular form of a noun corresponding to an item may include one or a plurality of the items unless clearly indicated otherwise in a related context.

In this document, phrases, such as "A or B", "at least one of A and B", "at least one of A or B," "A, B or C," "at least one of A, B and C," and "at least one of A, B, or C", may include any one or all possible combinations of items listed together in the corresponding phrase among the phrases.

As used herein, the term "and/or" includes any and all combinations of one or more of associated listed items.

Terms such as "1^{st}", "2^{nd}", or "first" or "second" may be used simply to distinguish a component from other components, without limiting the component in other aspects (e.g., importance or order).

A certain (e.g., a first) component is referred to as "coupled" or "connected" with or without the terms "functionally" or "communicatively" to another (e.g., second) component. When mentioned, it means that any of the above components can be connected to the other components directly (e.g., by wire), wirelessly, or via a third component.

It will be understood that when the terms "includes," "comprises," "including," and/or "comprising," when used in this specification, specify the presence of stated features, figures, steps, operations, components, members, or combinations thereof, but do not preclude the presence or addition of one or more other features, figures, steps, operations, components, members, or combinations thereof.

It will be understood that when a certain component is referred to as being "connected to", "coupled to", "supported by" or "in contact with" another component, it can be directly or indirectly connected to, coupled to, supported by, or in contact with the other component. When a component is indirectly connected to, coupled to, supported by, or in contact with another component, it may be connected to, coupled to, supported by, or in contact with the other component through a third component.

It will also be understood that when a component is referred to as being "on" or "over" another component, it can be directly on the other component or intervening components may also be present.

Meanwhile, in the following description, the terms "up-down direction", "lower side", "front-rear direction", etc. are defined based on the drawings, and the shapes and positions of the components are not limited by the terms.

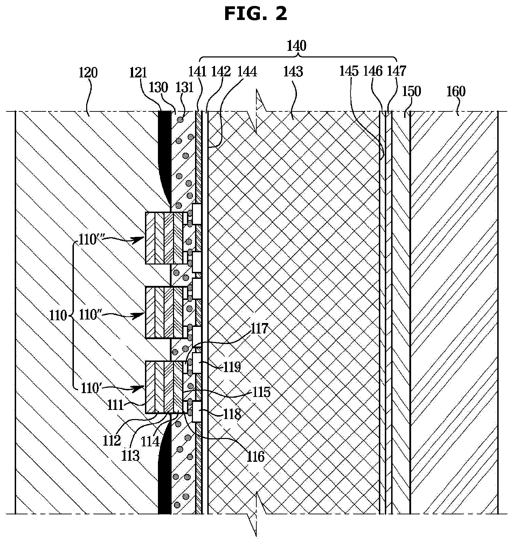

More specifically, as shown in FIG. 2, a direction in which a cooking room of a cooking apparatus opens may be defined as a front direction, and a rear direction, left and right directions, and upper and lower directions may be defined based on the front direction.

Hereinafter, an embodiment of the present disclosure will be described in detail with reference to the accompanying drawings.

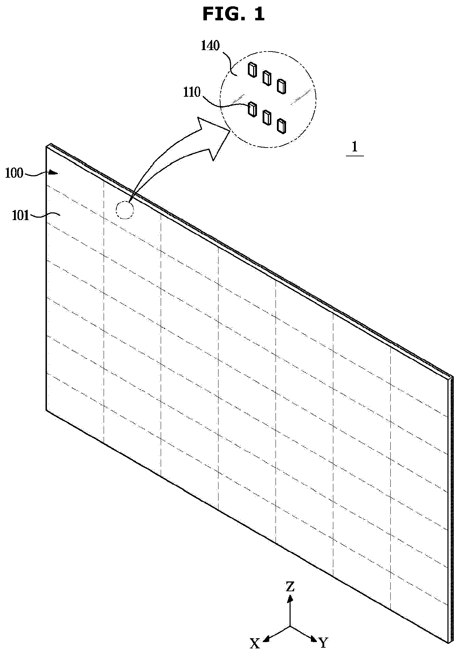

FIG. 1 is a perspective view of a display device according to an embodiment of the present disclosure.

A display device 1 according to the present disclosure will be described with reference to FIG. 1.

The display device 1 may be a device that displays information, data, and the like in the form of characters, figures, graphs, images, etc., and the display device 1 may be implemented as a TV, a PC, a mobile, a digital signage, etc.

In a front side of the display device 1, a display panel 100 may be positioned. The display panel 100 may be a part on which images are displayed.

A top chassis 30 may be provided along edges of the display panel 100. Therefore, the top chassis 30 may protect sides of the display panel 100.

The display panel 100 and the top chassis 30 may form a front appearance of the display device 1.

For convenience of manufacturing, the display panel 100 may be configured by mounting a plurality of display modules 101. FIG. 1 shows 49 display modules arranged in the form of a 7*7 matrix. However, this may be only an example and the number and arrangement of the display modules 101 are not limited thereto.

Each display module 101 may be formed in a quadrangular shape. That is, each display module 101 may be provided in a rectangular or square shape.

Accordingly, the display module 101 may include edges formed in upper, lower, left, and right directions as seen in a front direction.

The display panel 100 or the display module 101 may include a self-emissive display device or a non-emissive display device.

The self-emissive display device may itself emit light without using a separate light source to visually output an image. For example, a light-emitting diode (LED), an organic light-emitting diode (OLED), a quantum dot-organic light-emitting diode (QD-OLED), or an inorganic light-emitting device (or a micro LED) 110 made of an inorganic light-emitting material, etc. may be a device capable of itself emitting light based on supplied current.

The non-emissive display device may include a non-emissive display device requiring a separate light source. For example, although a Liquid Crystal Display (LCD) which is a non-emissive display device changes alignment of liquid crystals according to current, the LCD requires a separate light source to visually output an image through the changed alignment of liquid crystals.

The display device 1 according to the present disclosure may be applied to both a display panel 100 having a self-emissive display device and a display panel 100 having a non-emissive display device. However, for convenience of description, the display panel 100 including a self-emissive display device, more particularly, the light-emitting device 110 will be assumed and described.

As shown in FIG. 1, the light-emitting device 110 may be mounted on a module substrate 140. Hereinafter, this will be described in more detail with reference to FIG. 2.

FIG. 2 is a cross-sectional view showing a cross section cut around light-emitting devices shown in FIG. 1.

A light-emitting device according to an embodiment of the present disclosure and components related to the light-emitting device will be described with reference to FIG. 2.

Some components of the display device 1, including the plurality of light-emitting devices 110 shown in the drawing, may be micro-unit components each having a size of several µm to several hundred µm, and for convenience of description, some components (the light-emitting devices 110, a black matrix 121, etc.) may be exaggerated in scale.

Each light-emitting device 110 may be an organic light-emitting device or an inorganic light-emitting device. However, for convenience of description, in the following description, the light-emitting device is assumed to be an inorganic light-emitting device.

The display module 101 may include the module substrate 140 and the light-emitting devices 110 mounted on the module substrate 140. The light-emitting devices 110 may be mounted on a mounting surface 144 of the module substrate 140, which faces forward. In FIG. 2, a thickness of the module substrate 140 in a front direction is shown as exaggeratedly thick for convenience of description.

The module substrate 140 may be formed in a quadrangular shape. As described above, the display module 101 may be provided in a quadrangular shape, and the module substrate 140 may also be formed in a quadrangular shape correspondingly.

The module substrate 140 may be provided in a rectangular or square shape.

The module substrate 140 may include four edges formed in upper, lower, left, and right directions as shown in the front direction and corresponding to the edges of the display module 101.

The module substrate 140 may include a base substrate 143, a mounting surface 144 forming one surface of the base substrate 143, a rear surface 145 forming another surface of the base substrate 143 and being opposite to the mounting surface 144, and a side surface positioned between the mounting surface 144 and the rear surface 145.

The module substrate 140 may include a Thin Film Transistor (TFT) layer 142 formed on the base substrate 143 to drive the light-emitting devices 110. The base substrate 143 may include a glass module substrate 140. That is, the module substrate 140 may include a Chip On Glass (COG) type module substrate 140. The module substrate 140 may include a first pad electrode 118 to electrically connect the light-emitting devices 110 to the TFT layer 142.

TFTs configuring the TFT layer 142 are not limited to a specific structure or type and may be configured as various embodiments. That is, the TFTs of the TFT layer 142 according to an embodiment of the present disclosure may be implemented as Low Temperature Poly Silicon (LTPS) TFTs, oxide TFTs, Si (poly silicon or a-silicon) TFT, organic TFTs, graphene TFTs, etc.

Also, in the case in which the base substrate 143 of the module substrate 140 is provided as a silicon wafer, the TFT layer 142 may be replaced with a Complementary Metal-Oxide Semiconductor (CMOS) type or a n-type/p-type MOSFET transistor.

The light-emitting devices 110 may be formed of an inorganic material and may include light-emitting devices 110 each having sizes of several µm to several tens of µm in width, length, and height. A cross section in width, length, and height direction of each micro light-emitting device 110 may have a size of 100 µm or less. That is, the light-emitting devices 110 may be picked up from a wafer formed of a sapphire or silicon material and directly transferred onto the module substrate 140. The light-emitting devices 110 may be picked up and transferred through an electrostatic method using an electrostatic head or a stamp method using an elastic polymer material such as PDMS (for example, silicon), as a head.

Each of the light-emitting devices 110 may be a light-emitting structure including a n-type semiconductor 112, an active layer 113, a p-type semiconductor 114, a first contact electrode 116, and a second contact electrode 117.

Any of the first contact electrode 116 or the second contact electrode 117 may be electrically connected to the n-type semiconductor 112, and another one may be electrically connected to the p-type semiconductor 114, which is not shown in the drawing.

The first contact electrode 116 and the second contact electrode 117 may be in the form of flip chips arranged horizontally and facing the same direction (opposite to a light-emitting direction).

The light-emitting device 110 mounted on the mounting surface 144 may have a light-emitting surface 111 facing forward, a side surface, and a bottom surface 115 which is opposite to the light-emitting surface 111, and the first contact electrode 116 and the second contact electrode 117 may be formed on the bottom surface 115.

That is, the contact electrodes of the light-emitting device 110 may be opposite to the light-emitting surface 111, and accordingly, the contact electrodes may be positioned in an opposite direction of a direction in which light is irradiated.

The contact electrodes may face the mounting surface 144 and be electrically connected to the TFT layer 142. The light-emitting surface 111 that irradiates light may be positioned in the opposite direction of the direction in which the contact electrodes are positioned.

Accordingly, while light generated from the active layer 113 is irradiated in the front direction through the light-emitting surface 111, the light may be irradiated in the front direction without interfering with the first contact electrode 116 or the second contact electrode 117.

The front direction may be defined as a direction in which the light-emitting surface 111 is positioned to irradiate light.

The first contact electrode 116 and the second contact electrode 117 may respectively be electrically connected to the first pad electrode 118 and the second pad electrode 119 formed on the mounting surface 144 of the module substrate 140.

The light-emitting device 110 may be directly connected to the pad electrodes through a component such as an anisotropic conductive layer 130 or a solder.

The anisotropic conductive layer 130 may be formed on the module substrate 140 to mediate electrical bonding between the contact electrodes and the pad electrodes. The anisotropic conductive layer 130 may be formed by attaching an anisotropic conductive adhesive on a protective film and may have a structure in which conductive balls 131 are dispersed in an adhesive resin. The conductive balls 131 may be conductive spheres surrounded by thin insulating films, and according to the insulating films being broken by pressure, the conductive balls 131 may electrically connect conductors to each other.

The anisotropic conductive layer 130 may include an Anisotropic Conductive Film (ACF) in the form of a film and an Anisotropic Conductive Paste (ACP) in the form of a paste.

Accordingly, based on the light-emitting devices 110 being mounted on the module substrate 140, the insulating films of the conductive balls 131 may be broken according to pressure applied to the anisotropic conductive layer 130 to electrically connect the contact electrodes of the light-emitting devices 110 to the pad electrodes of the module substrate 140.

However, the plurality of light-emitting devices 110 may be mounted on the module substrate 140 through a solder (not shown), instead of the anisotropic conductive layer 130. After the light-emitting devices 110 are arranged on the module substrate 140, the light-emitting devices 110 may be bonded on the module substrate 140 through a reflow process.

Each light-emitting device 110 may include a red light-emitting device 110', a green light-emitting device 110", and a blue light-emitting device 110‴, and the light-emitting device 110 may be mounted on the mounting surface 144 of the module substrate 140 by using a series of the red light-emitting device 110', the green light-emitting device 110", and the blue light-emitting device 110‴ as a single unit. The series of the red light-emitting device 110', the green light-emitting device 110", and the blue light-emitting device 110"' may form one pixel. In this case, each of the red light-emitting device 110', the green light-emitting device 110", and the blue light-emitting device 110"' may form a sub pixel.

The red light-emitting device 110', the green light-emitting device 110", and the blue light-emitting device 110‴ may be arranged in a row at preset intervals as in an embodiment of the present disclosure, or may be arranged in another shape such as a triangular shape.

The module substrate 140 may include a light absorbing layer 141 that absorbs external light to improve contrast. The light absorbing layer 141 may be formed on the entire mounting surface 144 of the module substrate 140. The light absorbing layer 141 may be formed between the TFT layer 142 and the anisotropic conductive layer 130.

The display module 101 may further include the black matrix 121 formed between the light-emitting devices 110.

The black matrix 121 may function to supplement the light absorbing layer 141 formed on the entire mounting surface 144 of the module substrate 140. That is, the black matrix 121 may improve contrast of a screen by absorbing external light and making the module substrate 140 appear black.

The black matrix 121 may preferably have a black color.

In the current embodiment, the black matrix 121 may be formed to be positioned between pixels each formed by the series of the red light-emitting device 110', the green light-emitting device 110", and the blue light-emitting device 110"'. However, unlike the current embodiment, the black matrix 121 may be formed more finely to partition the light-emitting devices 110 which are sub pixels from each other.

The black matrix 121 may be formed in a grid shape having horizontal and vertical patterns to be positioned between the pixels.

The black matrix 121 may be formed by applying light-absorbing ink onto the anisotropic conductive layer 130 through an ink-jet process and then performing curing, or by coating a light-absorbing film on the anisotropic conductive layer 130.

That is, on the anisotropic conductive layer 130 formed on the entire mounting surface 144, the black matrix 121 may be formed between the light-emitting devices 110, where no light-emitting device 110 is mounted.

The display module 101 may include a front cover 120 positioned on the mounting surface 144 in the front direction to cover the mounting surface 144.

The front cover 120 may include a film (not shown).

The film (not shown) of the front cover 120 may be provided as a functional film having optical performance.

Generally, an adhesive layer (not shown) of the front cover 120 may have a height of a preset value or greater in the front direction which the mounting surface 144 or the light-emitting surface 111 faces. The front cover 120 may be positioned on the module substrate 140 in such a way as to sufficiently fill gaps that may be formed between the front cover 120 and the light-emitting devices 110.

Each display module 101 may include a gap prevention sheet 20 positioned on a rear surface of the module substrate 140 to dissipate heat generated from the module substrate 140.

Heat generated from the module substrate 140 may include heat generated from various components. A major part of heat generated from the module substrate 140 and transferred to the rear surface may be heat generated while the plurality of light-emitting devices 110 emit light. However, heat may be generated from a plurality of components such as the TFT layer 142 mounted on the mounting surface 144 of the module substrate 140, and the heat generated from the plurality of components may be transferred to the module substrate 140.

Also, heat may be transferred to the module substrate 140 from outside of the module substrate 140, or heat transferred to the module substrate 140 through another component than the module substrate 140 may be generated in the module substrate 140.

Heat generated from the module substrate 140, which will be described below, indicates heat generated from a plurality of components substantially including the light-emitting devices 110, positioned on the module substrate 140, and transferred to the module substrate 140.

Because a major part of heat generated from the plurality of light-emitting devices 110 is transferred to the module substrate 140, as described above, a largest proportion of heat generated from the module substrate 140 may be heat generated from the light-emitting devices 110. However, as described above, heat may be generated in the module substrate 140 by heat generated from various components other than the light-emitting devices 110 and the outside of the module substrate 140. Additionally, the display module 101 may include an adhesive tape 150 positioned between the gap prevention sheet 20 and the rear surface of the module substrate 140 to adhere the gap prevention sheet 20 to the rear surface of the module substrate 140.

The light-emitting devices 110 may be electrically connected to a pixel driving wiring (not shown) formed on the mounting surface 144 and an upper wiring layer (not shown) that extends along sides of the module substrate 140 and is formed by the pixel driving wiring (not shown).

The upper wiring layer (not shown) may be electrically connected to a side wiring (not shown) formed on the sides of the module substrate 140. The side wiring (not shown) may be provided as a thin film.

The upper wiring layer (not shown) may be connected to the side wiring (not shown) through an upper connection pad (not shown) formed at edges of the module substrate 140.

The side wiring (not shown) may extend along side surfaces of the module substrate 140 and be connected to a rear wiring layer 146 formed on the rear surface of the module substrate 140.

An insulating layer 147 for covering the rear wiring layer 146 may be formed on the rear wiring layer 146 in a direction in which the rear surface of the module substrate 140 faces.

That is, the plurality of light-emitting devices 110 may be electrically connected to the upper wiring layer (not shown), the side wiring (not shown), and the rear wiring layer 146, sequentially.

The gap prevention sheet 20 may be in contact with the module substrate 140, as described above. The gap prevention sheet 20 may be adhered to the module substrate 140 by the adhesive tape 150 positioned between the gap prevention sheet 20 and the rear surface of the module substrate 140.

The gap prevention sheet 20 may be formed of a material having high thermal conductivity or may be implemented as a component having high thermal conductivity. For example, the gap prevention sheet 20 may be formed of an aluminum material.

Heat generated from the light-emitting devices 110 mounted on the module substrate 140 and the TFT layer 142 may be transferred to the gap prevention sheet 20 through the adhesive tape 150 along the rear surface of the module substrate 140.

Accordingly, heat generated from the module substrate 140 may be easily transferred to the gap prevention sheet 20, which prevents a temperature of the module substrate 140 from rising to a certain temperature or higher.

The display modules 101 may be arranged at various positions in a M*N matrix form. The display modules 101 may be movable independently. In this case, because each of the display modules 101 includes the gap prevention sheet 20, the display module 101 may maintain preset heat dissipation performance regardless of a position of the display module 101.

The plurality of display modules 101 may be arranged in various M*N matrix forms to form various sizes of screens of the display device 1. Therefore, by including the gap prevention sheet 20 in each of the display modules 101 such that the display module 101 dissipates heat independently, as in an embodiment of the present disclosure, total heat dissipation performance of the display device 1 may be improved compared to heat dissipation through a single gap prevention sheet 20 provided for heat dissipation.

In the case in which a single gap prevention sheet 20 is positioned inside the display device 1, the gap prevention sheet 20 may not be positioned to correspond to locations where some display modules 101 are positioned or may be positioned at locations where no display modules 101 are positioned, in a front-rear direction, which may deteriorate heat dissipation efficiency of the display device 1.

That is, because all the display modules 101 dissipate heat independently regardless of positions of the display modules 101 through the gap prevention sheet 20 positioned on each display module 101, the total heat dissipation performance of the display device 1 may be improved.

The gap prevention sheet 20 may be provided in a quadrangular shape corresponding to the shape of the module substrate 140.

An area of the module substrate 140 may be at least equal to or larger than an area of the gap prevention sheet 20. In the case in which the module substrate 140 and the gap prevention sheet 20 are arranged in parallel in the front direction, four edges of the module substrate 140 having a rectangular shape may correspond to four edges of the gap prevention sheet 20 with respect to centers of the module substrate 140 and the gap prevention sheet 20 or may be located further outward than the four edges of the gap prevention sheet 20 with respect to the centers of the module substrate 140 and the gap prevention sheet 20.

Preferably, the four edges of the module substrate 140 may be located further outward than the four edges of the gap prevention sheet 20. That is, the area of the module substrate 140 may be larger than the area of the gap prevention sheet 20.

The module substrate 140 and the gap prevention sheet 20 may thermally expand while heat is transferred to the display module 101, and because the gap prevention sheet 20 has a higher thermal expansion rate than the module substrate 140, an expansion degree of the gap prevention sheet 20 may be greater than an expansion degree of the module substrate 140.

**In** this case, in the case in which the four edges of the module substrate 140 correspond to or are located further inward than the four edges of the gap prevention sheet 20, the edges of the gap prevention sheet 20 may protrude outward from the module substrate 140.

As a result, spacing lengths of gaps formed between the display modules 101 may become irregular due to the thermal expansion of the gap prevention sheet 20 of each display module 101, and accordingly, recognition of some seams may rise, resulting in deterioration of screen unity of the display panel 100.

However, according to the four edges of the module substrate 140 being located further outward than the four edges of the gap prevention sheet 20, the gap prevention sheet 20 may not protrude outward from the four edges of the module substrate 140 even when the module substrate 140 and the gap prevention sheet 20 thermally expand, and accordingly, spacing lengths of gaps formed between the display modules 101 may be maintained constant.

According to an embodiment of the present disclosure, the area of the module substrate 140 may substantially correspond to the area of the gap prevention sheet 20. Accordingly, heat generated from the module substrate 140 may be uniformly dissipated throughout the entire area of the module substrate 140 rather than being isolated in a certain area.

The gap prevention sheet 20 may be adhered to the rear surface of the module substrate 140 by the adhesive tape 150.

The adhesive tape 150 may have a size corresponding to the gap prevention sheet 20. That is, an area of the adhesive tape 150 may correspond to the area of the gap prevention sheet 20. The gap prevention sheet 20 may be provided in a substantially quadrangular shape and the adhesive tape 150 may also be provided in a quadrangular shape correspondingly.

The edges of the gap prevention sheet 20 having a rectangular shape may correspond to edges of the adhesive tape 150 with respect to centers of the gap prevention sheet 20 and the adhesive tape 150.

Accordingly, the gap prevention sheet 20 and the adhesive tape 150 may be easily manufactured as a combined component, which may increase manufacturing efficiency of the display device 1.

That is, before the gap prevention sheet 20 is cut into unit pieces from one plate, the adhesive tape 150 may be adhered to the one plate and the adhesive tape 150 and the gap prevention sheet 20 may be cut together into the unit pieces, thereby shortening a process.

Heat generated from the module substrate 140 may be transferred to the gap prevention sheet 20 through the adhesive tape 150. Accordingly, the adhesive tape 150 may adhere the gap prevention sheet 20 to the module substrate 140 while transferring heat generated from the module substrate 140 to the gap prevention sheet 20.

Accordingly, the adhesive tape 150 may include a material having high heat dissipation performance.

The adhesive tape 150 may include an adhesive material to adhere the gap prevention sheet 20 to the module substrate 140.

The adhesive tape 150 may include a material having high heat dissipation performance rather than a general adhesive material. Accordingly, heat may be efficiently transferred between the module substrate 140 and the gap prevention sheet 20.

Also, the adhesive material of the adhesive tape 150 may be formed of a material having higher heat dissipation performance than adhesive materials constituting existing adhesives.

The material having high heat dissipation performance may be a material capable of effectively transferring heat due to high thermal conductivity, a high heat transfer property, and low specific heat.

For example, the adhesive tape 150 may include, but is not limited to, a graphite material. However, the adhesive tape 150 may be formed of any material having high heat dissipation performance.

Flexibility of the adhesive tape 150 may be greater than flexibility of the module substrate 140 and flexibility of the gap prevention sheet 20. Accordingly, the adhesive tape 150 may be formed of a material having adhesiveness, heat dissipation properties, and great flexibility. The adhesive tape 150 may be a baseless double-sided tape. In this case, the adhesive tape 150 may be formed as a single layer of which one side is bonded on the module substrate 140 and another side is bonded on the gap prevention sheet 20, without having any base supporting the one side and the other side.

Because the adhesive tape 150 includes no base, the adhesive tape 150 may include no material interfering with heat conduction, and accordingly, heat dissipation performance may increase. However, the adhesive tape 150 is not limited to a baseless double-sided tape and may be provided as a heat dissipation tape having higher heat dissipation performance than existing double-sided tapes.

The module substrate 140 may include a glass material and the gap prevention sheet 20 may include a metal material. In this case, due to different material properties of the materials, the materials may be deformed to different degrees by the same heat. That is, upon heat generation from the module substrate 140, the module substrate 140 and the gap prevention sheet 20 may thermally expand to different sizes by the heat. Accordingly, the display module 101 may be damaged.

**In** the state in which the module substrate 140 and the gap prevention sheet 20 are fixed to each other, the module substrate 140 and the gap prevention sheet 20 may thermally expand to different sizes because the module substrate 140 and the gap prevention sheet 20 have different expansion values at the same temperature, and thus, stress may be generated in each of the module substrate 140 and the gap prevention sheet 20.

Among the material properties, different thermal expansion coefficients of the materials change physical deformation degrees of the materials by heat. Particularly, because a thermal expansion coefficient of a metal material is greater than a thermal expansion coefficient of glass, the same heat transferred to the module substrate 140 and the gap prevention sheet 20 may more expand and deform the gap prevention sheet 20 than the module substrate 140.

**In** contrast, even while heat generation from the module substrate 140 terminates and the module substrate 140 and the gap prevention sheet 20 are cooled, the gap prevention sheet 20 may be more contracted and deformed than the module substrate 140.

Because the gap prevention sheet 20 is adhered to the module substrate 140 by the adhesive tape 150, an external force may be transferred to the module substrate 140 while the gap prevention sheet 20 is more deformed than the module substrate 140.

**In** contrast, even when an external force is transferred to the gap prevention sheet 20 by the module substrate 140, the module substrate 140 may be damaged because a rigidity of the module substrate 140 made of a glass material is smaller than that of the gap prevention sheet 20 made of a metal material.

The adhesive tape 150 may absorb an external force transferred from other components between the module substrate 140 and the gap prevention sheet 20 while the module substrate 140 and the gap prevention sheet 20 expand to different sizes.

Accordingly, an external force may be prevented from being transferred to the module substrate 140 and the gap prevention sheet 20, and particularly, the module substrate 140 may be prevented from being damaged.

The adhesive tape 150 may be formed of a material having great flexibility to absorb an external force transferred from the module substrate 140 and the gap prevention sheet 20. More specifically, flexibility of the adhesive tape 150 may be greater than flexibility of the module substrate 140 and flexibility of the gap prevention sheet 20.

While an external force generated by changes in size of the module substrate 140 and the gap prevention sheet 20 is transferred to the adhesive tape 150, the adhesive tape 150 may itself be deformed to prevent the external force from being transferred to other components.

The adhesive tape 150 may have a preset thickness in the front direction. While heat is transferred to the gap prevention sheet 20 and thus, the gap prevention sheet 20 thermally expands or is cooled and contracts, the gap prevention sheet 20 may expand or contract in a direction that is orthogonal to the front direction, as well as in the front direction, and accordingly, an external force may be transferred to the module substrate 140.

The display panel 100 may display a screen by the plurality of display modules 101, as described above. At this time, due to seams formed by gaps formed between the plurality of display modules 101, screen unity may deteriorate.

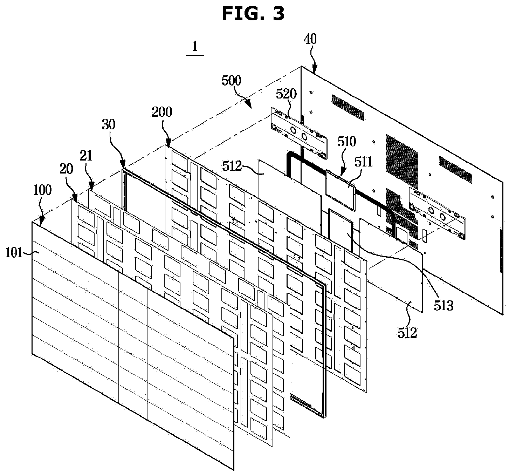

Accordingly, to minimize recognition of the seams of the display panel 100, the plurality of display modules 101 may be arranged with constant gaps on the rear chassis 200 (see FIG. 3). In the case in which the gaps formed by the plurality of display modules 101 are not constant, recognition of the seams may be amplified by some gaps.

In an existing display device 1, a rear chassis 200 supporting a display panel 100 may be made of a metal material. A plurality of display modules 101 may be tiled on the rear chassis 200 made of the metal material.

While the display device 1 is driven, module substrates 140 forming the plurality of display modules 101 may thermally expand by heat generated from the display panel 100. Because the plurality of display modules 101 are supported on the rear chassis 200 made of the metal material, as described above, gaps between the plurality of display modules 101 may become irregular due to the thermal expansion of the module substrates 140 and thermal expansion of the rear chassis 200, which amplifies recognition of seams.

That is, because all the module substrates 140 of the plurality of display modules 101 are made of a glass material and thermally expand to a constant degree, some of the gaps between the plurality of display modules 101 may become irregular in width due to thermal expansion of the rear chassis 200 made of the metal material and supporting the respective module substrates 140. The reason may be because material properties of a metal material are different from material properties of glass.

Material properties of a material may depend on a thermal expansion coefficient, specific heat, and thermal conductivity. Particularly, due to a difference between a thermal expansion coefficient of a metal material and a thermal expansion coefficient of glass, a degree of thermal expansion of the module substrate 140 may be different from a degree of thermal expansion of the rear chassis 200.

In addition to the thermal expansion of the module substrates 140 of the plurality of display modules 101, the rear chassis 200 adhered to the plurality of display modules 101 may also itself thermally expand, which may cause irregular spacing lengths of the gaps between the plurality of display modules 101.

To prevent the gaps between the plurality of display modules 101 arrayed on the rear chassis 200 made of a metal material from becoming irregular due to thermal expansion, the rear chassis 200 of the display device 1 according to an embodiment of the present disclosure, to which the plurality of display modules 101 are adhered, may be made of a material having material properties that are similar to those of the module substrates 140 of the plurality of display modules 101.

That is, the rear chassis 200 may have material properties that are similar to those of the module substrate 140 to maintain constant spacing lengths of the gaps formed between the display modules 101.

That the rear chassis 200 has material properties that are similar to those of the module substrate 140 may mean that the rear chassis 200 has a thermal expansion coefficient, specific heat, and thermal conductivity that are similar to those of the module substrate 140. Particularly, according to an embodiment of the present disclosure, it may mean that a thermal expansion coefficient of the rear chassis 200 corresponds to a thermal expansion coefficient of the module substate 140.

The rear chassis 200 may be made of a material having material properties that are similar to those of the module substrate 140 or may be made of a material having a thermal coefficient value that is similar to that of the module substrate 140. Preferably, the rear chassis 200 may be, but is not limited to, formed of a material having the same thermal coefficient as the module substrate 140.

However, the rear chassis 200 may include a front layer (not shown) formed of a material having material properties that correspond to those of the module substrate 140.

By adhering the front layer (not shown) onto the module substrate 140 in the front direction, while the same heat is transferred to the module substrate 140 and the front layer (not shown) in a second direction or a third direction that is orthogonal to the front direction, the module substrate 140 and the front layer (not shown) may expand to a corresponding length

That is, the rear chassis 200 may be formed of a material having material properties that correspond to those of the module substrate 140, or only the front layer (not shown) forming a front side of the rear chassis 200 may be formed of a material having material properties that correspond to those of the module substrate 140. **In** both embodiments, the front side of the rear chassis 200, to which the module substrate 140 of the display module 101 is adhered, may thermally expand to the same degree as the module substrate 140 while the module substrate 140 of the display module 101 thermally expands by heat generated during operation of the display device 1.

Because the front side of the rear chassis 200 as a base side to which the display module 101 is adhered thermally expands to the same degree as the module substrate 140 of the display module 101, the gaps formed between the display modules 101 may be maintained at the same spacing.

Accordingly, because the gaps formed between the plurality of display modules 101 are maintained at the same spacing distance as when the module substrate 140 does not thermally expand, seams may be maintained at a preset level and screen unity of the display panel 100 may be maintained.

Even though heat generated according to operation of the display device 1 is applied to the module substrates 140 of the plurality of display modules 101, a phenomenon in which some seams are amplified to deteriorate screen unity may be prevented because the gaps between the plurality of display modules 101 are maintained at constant distances.

The rear chassis 200 which supports the display panel 100 may have a rigidity of a preset level or higher. Accordingly, the rear chassis 200 may be formed of a metal material having a rigidity of a preset level or higher, and the front side of the rear chassis 200 may be formed of a glass material corresponding to the module substrate 140. However, the present disclosureis not limited thereto, and the rear chassis 200 may be formed of a material having a different thermal expansion coefficient from the module substrate 140.

So far, an embodiment of the display panel 100 including the light-emitting devices 110 has been described. Hereinafter, components of the display device 1 will be described based on a method by which the display panel 100 is coupled inside the display device 1.

FIG. 3 is an exploded perspective view of the display device shown in FIG. 1.

Components included in the display device according to an embodiment of the present disclosure will be described with reference to FIG. 3.

The display panel 100 may include the plurality of display modules 101 as described above. The plurality of display modules 101 may display an image together.

The rear chassis 200 having a shape corresponding to the display panel 100 may be provided behind the display panel 100. Accordingly, the rear chassis 200 may also be provided in a rectangular shape, like the display panel 100.

The display panel 100 may be coupled to the rear chassis 200. As described above, the rear chassis 200 may support the display panel 100. In the case in which the display panel 100 includes self-emissive inorganic light-emitting devices 110, the display device 1 may not require a backlight unit. In a non-emissive display device including a backlight, the rear chassis 200 supporting the backlight may function to support the display panel 100. However, in the display device 1 including no backlight, a separate component for supporting the display panel 100 may be required. By coupling the rear chassis 200 having a rigidity capable of supporting the display panel 100 to the rear side of the display panel 100, bending of the display panel 100 may be prevented.

The rear chassis 200 may include a substrate penetrating space 200S penetrating the rear chassis 200 in the front-rear direction. Each display module 101 may be connected to a control substrate 510 located behind the rear chassis 200 through the substrate penetrating space 200S.

The display device 1 may include the top chassis 30.

The top chassis 30 may be a component that supports the display panel 100.

The top chassis 30 may extend along the edges of the display panel 100. The top chassis 30 may cover at least a part of the edges of the display panel 100.

The display panel 100 may have a rectangular shape. **In** this case, the top chassis 30 may also have a shape extending along edges of the rectangular shape.

The rear chassis 200 may have a shape corresponding to the display panel 100, and the top chassis 30 may have a shape extending along the edges of the rear chassis 200.

The top chassis 30 may extend toward an inner part of the display device 1. More specifically, the top chassis 30 may extend in a direction that is parallel to the display panel 100. The rear chassis 200 may be coupled by being rested in an accommodating space formed by this shape. The rear chassis 200 may be supported by this portion.

The top chassis 30 may include, but is not limited to, a metal material.

The top chassis 30 may be formed by a press process, although not limited thereto.

The display device 1 may include the gap prevention sheet 20. The gap prevention sheet 20 may be a component for preventing gaps from being formed between the plurality of display modules 101.

The gap prevention sheet 20 may have a shape corresponding to the display panel 100. The gap prevention sheet 20 may have a substantially rectangular shape. Therefore, the gap prevention sheet 20may be attached to the display panel 100 without leaving any part.

The gap prevention sheet 20 may have a shape corresponding to the rear chassis 200. Therefore, the gap prevention sheet 20 may be evenly supported by the rear chassis 200.

The gap prevention sheet 20 may be positioned between the display panel 100 and the rear chassis 200. The gap prevention sheet 20 may be supported by the rear chassis 200.

The gap prevention sheet 20 may be adhered to the display panel 100.

The gap prevention sheet 20 may have a heat transfer coefficient that is similar to that of the display modules 101. Therefore, while heat is transferred to the plurality of display modules 101, the gap prevention sheet 20 may expand to the same degree to which the plurality of display modules 101 expand, thereby preventing formation of gaps between the plurality of display modules 101.

That is, due to a difference in thermal expansion coefficient between the rear chassis 200 and the plurality of display modules 101, which will be described below, a degree to which the rear chassis 200 is deformed while heat is applied thereto may be different from a degree to which the plurality of display modules 101 are deformed. Therefore, gaps between the plurality of display modules 101 may expand. The reason may be because the degree to which the rear chassis 200 expands may be greater than the degree to which each of the plurality of display modules 101 expands. To adjust the thermal expansion degrees, the gap prevention sheet 20 may be provided.

That is, the gap prevention sheet 20 may be positioned between the plurality of display modules 101 and the rear chassis 200. The thermal expansion coefficient of the gap prevention sheet 20 may have a value that is closer to the thermal expansion coefficient of the plurality of display modules 101 than the thermal expansion coefficient of the rear chassis 200 to prevent formation of gaps between the plurality of display modules 101.

The display device 1 may include a deformation prevention sheet 21. The deformation prevention sheet 21 may be a sheet that prevents deformation of the display panel 100.

The deformation prevention sheet 21 may have a shape corresponding to the display panel 100. The deformation prevention sheet 21 may have a substantially rectangular shape. Therefore, the deformation prevention sheet 21 may be attached to the display panel 100 without leaving any part.

The deformation prevention sheet 21 may have a shape corresponding to the rear chassis 200. Therefore, the deformation prevention sheet 21 may be evenly supported by the rear chassis 200.

The deformation prevention sheet 21 may be positioned between the display panel 100 and the rear chassis 200. The deformation prevention sheet 21 may be supported by the rear chassis 200.

The deformation prevention sheet 21 may have a lower heat transfer coefficient than those of the rear chassis 200 and the display modules 101. That is, the deformation prevention sheet 21 may have an insulating function.

The deformation prevention sheet 21 may prevent heat generated by the display panel 100 from being transferred to the rear chassis 200. Also, the deformation prevention sheet 21 may prevent heat generated from electronic equipment 500 being in contact with the rear chassis 200, which will be described below, from being transferred to the display panel 100. This may be to prevent deformation by heat.

That is, the deformation prevention sheet 21 may be positioned between the gap prevention sheet 20 and the rear chassis 200. The thermal expansion coefficient of the deformation prevention sheet 21 may be lower than those of the gap prevention sheet 20 and the rear chassis 200 to prevent deformation of the rear chassis 200 from being transferred to the gap prevention sheet 20.

The display device 1 may include the electronic equipment 500. The electronic equipment 500 may be various components for driving the display device 1.

The electronic equipment 500 may be positioned on one side of the rear chassis 200. The electronic equipment 500 may be positioned behind the rear chassis 200.

The electronic equipment 500 may be mounted on the rear chassis 200.

The electronic equipment 500 may include the control substrate 510. The control substrate 510 may be a substrate for driving the display panel 100 or the display modules 101.

The control substrate 510 may include a power board 512.

The power board 512 may be a component for supplying power to the display panel 100.

The control substrate 510 may include a main board 511.

The main board 511 may be a component for controlling overall operations of the display panel 100 or controlling the power board 512.

The control substrate 510 may include a timing control board 513.

The timing control board 513 may be a component that generates a timing signal required to control the main board 511 or the display panel 100.

The electronic equipment 500 may include a speaker 520.

The speaker 520 may be a component that outputs sound.

The display device 1 may include a rear cover 40. The rear cover 40 may be a component for covering the electronic equipment 500 and the rear chassis 200.

The rear cover 40 may have a shape corresponding to the rear chassis 200. The rear cover 40 may have a substantially rectangular shape.

The rear cover 40 may be coupled to the top chassis 30. The rear cover 40 may be installed on a rear side of the top chassis 30. The rear cover 40 may be supported by the top chassis 30.

The rear cover 40 may include a plastic material.

The rear cover 40 may be formed by injection molding.

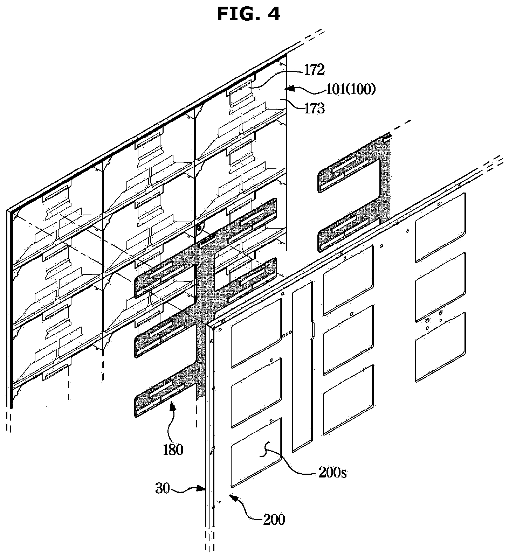

FIG. 4 is a rear exploded perspective view showing some of disassembled parts of the display device shown in FIG. 1.

A display module according to an embodiment of the present disclosure will be described with reference to FIG. 4.

Each display module 101 may include a module plate 113 positioned on an opposite surface of the mounting surface of the module substrate 140. The module plate 113 may be manufactured in the form of a thin film or sheet or may be attached to the module substrate 140 through an adhesive or a heat dissipation tape. The module plate 113 may be positioned between the module substrate 140 and a module connecting substrate 112 in an opposite direction of a light-emitting direction of inorganic LEDs.

The module plate 113 may include a material having thermal conductivity for heat dissipation of the display module 101. The module plate 113 may include a material having a rigidity of a preset level or higher to reinforce strength of the display module 101 and prevent damage. The module plate 113 may prevent light leakage from the module substrate 140 according to the module substrate 140 being made of a translucent material. The module plate 113 may improve visibility of the display device 1. The module plate 113 may include aluminum (Al).

The display module 101 may include the module connecting substrate 112. One end of the module connecting substrate 112 may be electrically connected to the opposite surface of the mounting surface of the module substrate 140. Another end of the module connecting substrate 112 may be electrically connected to a module control substrate 180. The module connecting substrate 112 may be provided as a flexible printed circuit board (FPCB). The display module 101 may receive power or data required for driving through the module connecting substrate 112. A plurality of module connecting substrates 112 may be provided.

The module control substrate 180 may be electrically connected to the control substrate.

The display module 101 may be coupled to the rear chassis 200 by a screw.

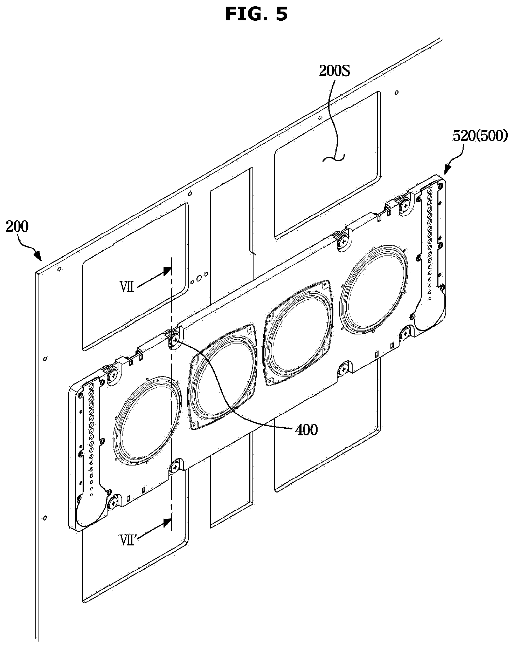

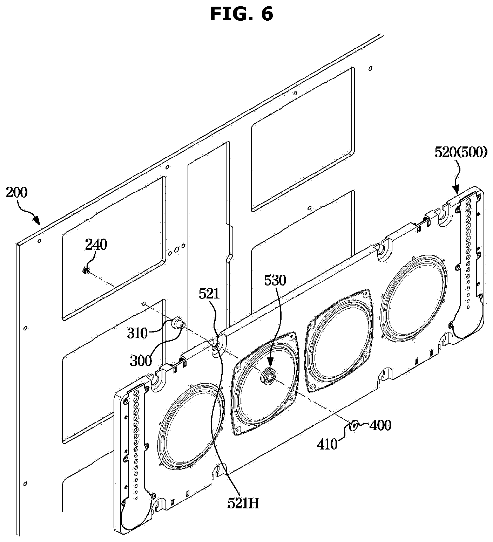

FIG. 5 is a rear perspective view showing components related to the rear chassis 200 and the electronic equipment 500 shown in FIG. 3. FIG. 6 is a rear exploded perspective view showing the components related to the rear chassis 200 and the electronic equipment 500 shown in FIG. 5.

The display device 1 may include the rear chassis 200.

The rear chassis 200 may support the display panel 100.

The rear chassis 200 may have a rigidity sufficient to support the electronic equipment 500 coupled thereto.

The rear chassis 200 may have a plate shape.

The rear chassis 200 may include a stud nut 240.

The stud nut 240 may be coupled with a stud 300 which will be described below.

The stud nut 240 may have a cylinder shape with a hole defined in the center.

The stud nut 240 may include, but is not limited to, a metal material.

The stud nut 240 may be formed by casting, although not limited thereto.

The display device 1 may include the electronic equipment 500.

The electronic equipment 500 may be coupled to the rear chassis 200. For example, the electronic equipment 500 may be coupled to the rear chassis 200 by a coupling member 400. Alternatively, the electronic equipment 500 may be coupled to the rear chassis 200 by the stud 300.

The electronic equipment 500 may be capable of generating vibration. For example, according to the electronic equipment 500 being a speaker 520, the speaker 520 may generate vibration because the speaker 520 generates sound by vibrating air.

While the electronic equipment 500 generates vibration, the display panel 100 (see FIG. 3) may be damaged by the vibration generated by the electronic equipment 500. Particularly, according to the display panel 100 including the plurality of display modules 101, the gaps between the plurality of display modules 101 may expand by vibration generated by the speaker 520. To prevent this, the electronic equipment 500 may need to be spaced apart from the rear chassis 200.

The stud 300 which will be described below may couple the electronic equipment 500 to the rear chassis 200 while spacing the electronic equipment 500 from the rear chassis 200.

The electronic equipment 500 may include an insertion hole 521H.

The insertion hole 521H may be a hole into which the stud 300 which will be described below is inserted.

That is, the electronic equipment 500 may be adjacent to the rear chassis 200 and have the insertion hole 521H.

The electronic equipment 500 may include a hole forming portion 521 that defines the insertion hole 521H.

The hole forming portion 521 may have a smaller thickness than other adjacent portions.

The electronic equipment 500 may include a vibration reducing member 530. The vibration reducing member 530 may be a component for reducing transfer of vibration generated in the electronic equipment 500 to the rear chassis 200.

That is, the vibration reducing member 530 may prevent vibration of the electronic equipment 500 from being transferred to the stud 300.

At least a part of the vibration reducing member 530 may be accommodated into the insertion hole 521H.

The vibration reducing member 530 may prevent vibration generated in the electronic equipment 500 from being transferred to the stud 300 which will be described below. The vibration reducing member 530 may be positioned between the hole forming portion 521 and the stud 300.

The vibration reducing member 530 may include, but is not limited to, a rubber material.

The vibration reducing member 530 may be formed by injection molding, although not limited thereto.

The vibration reducing member 530 may include an accommodating groove 533H.

The accommodating groove 533H may be provided to insert the vibration reducing member 530 into the hole forming portion 521.

The vibration reducing member 530 may include a vibration reducing hole 531H.

The stud 300 may penetrate the vibration reducing hole 531H.

The display device 1 may include the stud 300.

The stud 300 may protrude from the rear chassis 200 and penetrate the electronic equipment 500. The stud 300 may protrude backward.

The stud 300 may penetrate the insertion hole 521H of the electronic equipment 500.

The stud 300 may penetrate the vibration reducing hole 531H of the vibration reducing member 530.

The stud 300 may be coupled to the rear chassis 200. The stud 300 may be coupled to the stud nut 240. The stud nut 240 may include a metal material. **In** this case, coupling of the stud 300 and the stud nut 240 may be coupling of rigid bodies. Accordingly, the stud 300 may be strongly coupled with the stud nut 240.

That is, the stud 300 may be coupled to the rear chassis 200 with a first coupling force in such a way as to protrude from the rear chassis 200.

The stud 300 may include, but is not limited to, a metal material.

The stud 300 may be formed by casting, although not limited thereto.

The stud 300 may include a chassis coupling portion 310. The chassis coupling portion 310 may be a part coupled to the rear chassis 200.

The chassis coupling portion 310 may be screw-coupled to the rear chassis 200, although not limited thereto. However, the chassis coupling portion 310 may be coupled to the rear chassis 200 by various methods, such as using an adhesive 250.

The chassis coupling portion 310 may protrude from the rear chassis 200 by penetrating at least a part of the rear chassis 200. The chassis coupling portion 310 may protrude toward the front direction.

The chassis coupling portion 310 may be accommodated in the rear chassis 200. The chassis coupling portion 310 may be accommodated in the stud nut 240.

That is, the chassis coupling portion 310 may be inserted into the rear chassis 200 and have a stud thread 311.

The display device 1 may include the coupling member 400.

The chassis coupling portion 310 may be inserted into the rear chassis 200 along an extension direction of the stud 300.

The chassis coupling portion 310 may be inserted into the rear chassis 200 by coming in contact with the rear chassis 200 by a chassis contact area.

The coupling member 400 may be coupled to the stud 300.

By coupling of the coupling member 400 and the stud 300, the electronic equipment 500 may be prevented from departing from the rear chassis 200.

The coupling member 400 may be, for example, a screw, a rivet, or the like.

The coupling member 400 may include, but is not limited to, a metal material.

The coupling member 400 may be formed by casting, although not limited thereto.

The coupling member 400 may include a stud coupling portion 410. The stud coupling portion 410 may be a part capable of being coupled to the stud 300.

The stud coupling portion 410 may protrude to be accommodated in the stud 300. The stud coupling portion 410 may protrude toward the front direction.

The stud coupling portion 410 may be screw-coupled with the stud 300, although not limited thereto. However, the stud coupling portion 410 may be coupled with the stud 300 by the adhesive 250, etc.

Because the stud coupling portion 410 is coupled with the stud 300 made of a metal material, the stud coupling portion 410 may be strongly coupled with the stud 300.

That is, the stud coupling portion 410 may include a coupling member thread 411 capable of being inserted into the stud 300.

The stud coupling portion 410 may have the coupling member thread 411 capable of being inserted into the stud 300 along an extension direction of the coupling member 400.

The stud coupling portion 410 may be inserted into the stud 300 by coming in contact with the stud 300 by a stud (300) contact area.

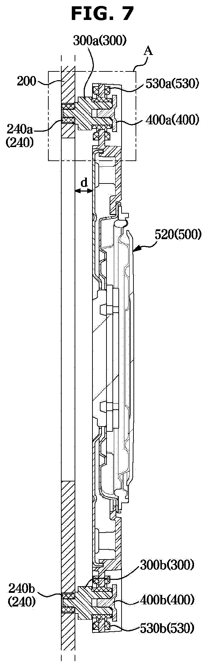

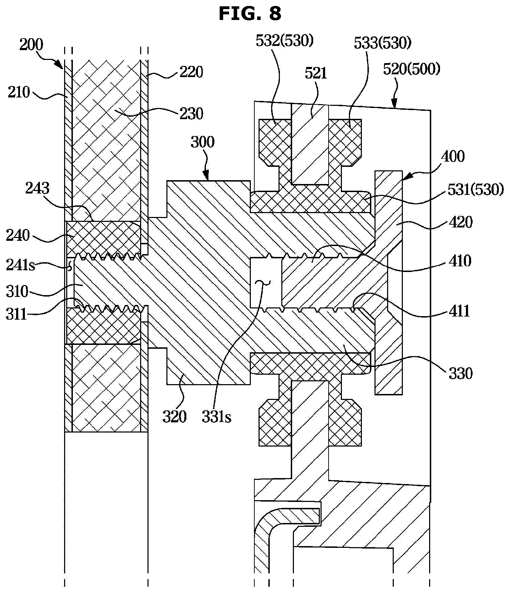

FIG. 7 is a cross-sectional view of the components related to the rear chassis 200 and the electronic equipment 500 shown in FIG. 5, taken along line VII-VII'. FIG. 8 is an exploded cross-sectional view of a part A of FIG. 7.

Coupling of the electronic equipment 500 and the rear chassis 200 according to an embodiment of the present disclosure will be described with reference to FIGS. 7 and 8.

A plurality of studs 300 may be provided. The plurality of studs 300 may include a first stud 300a and a second stud 300b. The first stud 300a may be adjacent to one end of the electronic equipment 500 and the second stud 300b may be adjacent to another end of the electronic equipment 500, which is opposite to the one end of the electronic equipment 500. For example, the first stud 300a may be adjacent to an upper end of the electronic equipment 500 and the second stud 300b may be adjacent to a lower end of the electronic equipment 500.

A plurality of coupling members 400 may be provided. The plurality of coupling members 400 may include a first coupling member 400a and a second coupling member 400b. The first coupling member 400a may be coupled with the first stud 300a and the second coupling member 400b may be coupled with the second stud 300b.

A plurality of stud nuts 240 may be provided. The plurality of stud nuts 240 may include a first stud nut 240 and a second stud nut 240. The first stud nut 240 may be coupled with the first stud 300a and the second stud nut 240 may be coupled with the second stud 300b.

A plurality of vibration reducing members 530 may be provided. The plurality of vibration reducing members 530 may include a first vibration reducing member 530a and a second vibration reducing member 530b. The first vibration reducing member 530a may be adjacent to the first stud 300a and the second vibration reducing member 530b may be adjacent to the second stud 300b.

As described above, a plurality of components may be provided to connect the electronic equipment 500 to the rear chassis 200.

The rear chassis 200 may include a first metal layer 210.

The first metal layer 210 may have substantially a plate shape.

The first metal layer 210 may face the display panel 100 (see IFG. 5). The first metal layer 210 may be positioned on the front side of the rear chassis 200.

That is, the first metal layer 210 may be positioned on a side facing the display panel 100.

The display panel 100 may include the plurality of display modules 101 (see FIG. 5) and the rear chassis 200 supporting the display modules 101 may need to be flat to minimize gaps between the plurality of display modules 101.

That is, the display panel 100 may include the plurality of display modules 101 that are adjacent to each other. The plurality of display modules 101 may face the first metal layer 210.

The first metal layer 210 may support the plurality of display modules 101.

The first metal layer 210 may include a metal material. Therefore, the first metal layer 210 may have a rigidity sufficient to support the plurality of display modules 101.

That is, the first metal layer 210 may support the plurality of display modules 101 to prevent steps from being formed between the plurality of display modules 101.

The first metal layer 210 may be formed by a press process, although not limited thereto.

The rear chassis 200 may include a second metal layer 220.

The second metal layer 220 may have substantially a plate shape.

The second metal layer 220 may be opposite to the first metal layer 210. The second metal layer 220 may be positioned behind the first metal layer 210. The second metal layer 220 may be positioned on the rear side of the rear chassis 200.

That is, the second metal layer 220 may be positioned on a side facing the electronic equipment 500.

The second metal layer 220 may include, but is not limited to, a metal material.

The second metal layer 220 may be formed by a press process, although not limited thereto.

The rear chassis 200 may include a resin layer 230.

The resin layer 230 may have substantially a plate shape.

The resin layer 230 may be positioned between the first metal layer 210 and the second metal layer 220.

As described above, in order to prevent gaps from being formed between the plurality of display modules 101, it may be desirable for the rear chassis 200 supporting the plurality of display modules 101 to have little deformation.

However, in the case in which the first metal layer 210 and the second metal layer 220 are thin, a degree of deformation may increase with respect to a force applied to the first metal layer 210 and the second metal layer 220 in a thickness direction or the front-back direction. That is, a degree of shear deformation may increase with respect to a shear stress in the thickness direction.

To prevent this, the first metal layer 210 and the second metal layer 220 may have great thicknesses.

According to the resin layer 230 being positioned between the first metal layer 210 and the second metal layer 220, a degree of sheer deformation in the thickness direction, required for the first metal layer 210 and the second metal layer 220, may be reduced. In addition, because the first metal layer 210 or the second metal layer 220 has a small degree of vertical deformation with respect to vertical stress in the thickness direction, a required physical quantity may be obtained.

According to the resin layer 230 being positioned between the first metal layer 210 and the second metal layer 220, the rear chassis 200 may be lighter than when the rear chassis 200 is made of only metal. Furthermore, in the case in which material cost of the resin layer 230 is lower than that of the first metal layer 210 or the second metal layer 220, manufacturing cost of the rear chassis 200 may be reduced.

That is, the resin layer 230 may be positioned between the first metal layer 210 and the second metal layer 220. The chassis coupling portion 310 may be inserted in the resin layer 230. The resin layer 230 may have a lower density than the first metal layer 210 and the second metal layer 220 and may be deformable.

The resin layer 230 may include, but is not limited to, a plastic material.

The resin layer 230 may be formed by injection molding, although not limited thereto.

The rear chassis 200 may include the stud nut 240.

The stud nut 240 may be accommodated in the resin layer 230.

The stud nut 24 may include a metal material. In this case, the stud nut 240 may strengthen coupling of the stud 300 and the rear chassis 200 compared to when the stud 300 is inserted into the resin layer 230.

That is, the stud nut 240 may be positioned in the resin layer 230 to prevent the chassis coupling portion 310 from being coupled to the resin layer 230. The stud nut 240 may be coupleable with the chassis coupling portion 310. The stud nut 240 may include a metal material and the stud 300 may include a metal material. In this case, the stud 300 may be strongly coupled with the stud nut 240.

The stud nut 240 may include a nut protrusion 243.

A plurality of nut protrusions 243 may be provided. The plurality of nut protrusions 243 may have a serration shape on a surface of the stud nut 240, which comes into contact with the resin layer 230. Therefore, the nut protrusions 243 may cause a strong friction force between the stud nut 240 and the resin layer 230.

That is, the stud nut 240 may include the nut protrusions 243 protruding toward the resin layer 230 to enhance a friction force with the resin layer 230.

The stud 300 may be coupled with the stud nut 240.

The stud 300 may include the chassis coupling portion 310. The chassis coupling portion 310 may be coupled with the stud nut 240.

The chassis coupling portion 310 may include a stud thread 311 coupled with the stud nut 240.

The stud thread 311 may protrude outward from the stud 300.

The stud 300 may include a stud supporting portion 320.

The stud supporting portion 320 may have a cylinder shape.

The stud supporting portion 320 may have a greater diameter than the insertion hole 521H. Accordingly, the stud supporting portion 320 may be prevented from passing through the insertion hole 521H.

The stud supporting portion 320 may be positioned between the rear chassis 200 and the electronic equipment 500. The electronic equipment 500 may be spaced apart from the rear chassis 200 by the stud supporting portion 320. The stud supporting portion 320 may support both the rear chassis 200 and the electronic equipment 500.

The electronic equipment 500 may generate vibration.

To prevent vibration generated in the electronic equipment 500 from being transferred to the display panel 100 (see FIG. 3), the stud supporting portion 320 may be positioned between the electronic equipment 500 and the rear chassis to space the electronic equipment 500 apart from the rear chassis 200.

The chassis coupling portion 310 may extend from the stud supporting portion 320.

The stud 300 may include a stud inserting portion 330.

The stud inserting portion 330 may have a cylinder shape. The stud inserting portion 330 may protrude toward the rear direction.

The stud inserting portion 330 may have a smaller diameter than the insertion hole 521H. Therefore, the stud inserting portion 330 may pass through the insertion hole 521H.

The stud inserting portion 330 may be positioned by penetrating the electronic equipment 500.

At least a part of the stud inserting portion 330 may be accommodated in the insertion hole 521H. At least a part of the stud inserting portion 330 may be accommodated in the vibration reducing hole 531H.

The stud inserting portion 330 may include a thread in the inner side into which the coupling member 400 is inserted. The thread included in the stud inserting portion 330 may be a thread of a female screw.

That is, the stud inserting portion 330 may extend from the stud supporting portion 320 and be inserted into the insertion hole 521H. The coupling member 400 may be coupled with the stud inserting portion 330.

The display device 1 may include the coupling member 400.

The coupling member 400 may be coupled with the stud 300 to couple the electronic equipment 500 to the rear chassis 200. The coupling member 400 may be coupled with the stud inserting portion 330.

The coupling member 400 may be coupled with the stud inserting portion 330 to prevent the electronic equipment 500 from departing from the stud 300 and the coupling member 400. The coupling member 400 may be accommodated into the stud inserting portion 330 from behind the stud inserting portion 330.

The coupling member 400 may include a coupling member head 420.

The coupling member head 420 may have substantially a cylinder shape.

The coupling member head 420 may include, at a portion positioned toward outside, a hole or groove into which a tool such as a driver is insertable.

The coupling member head 420 may be formed to have a greater diameter than the insertion hole 521H of the electronic equipment 500. The coupling member head 420 may be formed to have a greater diameter than the vibration reducing hole 531H of the vibration reducing member 530.

The coupling member head 420 may be positioned such that the hole forming portion 521 of the electronic equipment 500 is positioned between the coupling member head 420 and the stud supporting portion 320 of the stud 300. The coupling member head 420 may be positioned such that the insertion hole 521H of the electronic equipment 500 is positioned between the coupling member head 420 and the stud supporting portion 320 of the stud 300. The coupling member head 420 may be positioned behind the insertion hole 521H of the electronic equipment 500. Therefore, the coupling member head 420 and the stud supporting portion 320 of the stud 300 may prevent the hole forming portion 521 of the electronic equipment 500 from being decoupled from the rear chassis 200. The hole forming portion 521 of the electronic equipment 500 may be prevented from moving toward the coupling member head 420. The hole forming portion 521 of the electronic equipment 500 may be prevented from moving toward the stud supporting portion 320 of the stud 300. Because the hole forming portion 521 of the electronic equipment 500 is prevented from moving, the electronic equipment 500 may be prevented from moving. That is, the stud supporting portion 320 of the stud 300 and the coupling member head 420 may prevent the electronic equipment 500 from being decoupled from the rear chassis 200.

That is, the coupling member 400 may be coupled to the stud 300 with a second coupling force by penetrating the insertion hole 521H of the electronic equipment 500 such that the electronic equipment 500 is installed on the rear chassis 200, or the coupling member 400 may be separated from the stud 300. The coupling member head 420 may have a greater diameter than the insertion hole 521H.

The coupling member 400 may include the stud coupling portion 410.

The stud coupling portion 410 may extend from the coupling member head 420.

The stud coupling portion 410 may protrude from the coupling member head 420 to be accommodated in the stud inserting portion 330 of the stud 300. The stud coupling portion 410 may protrude toward the front direction.

The stud coupling portion 410 may have substantially a cylinder shape.

The stud coupling portion 410 may have a smaller diameter than the coupling member head 420. The stud coupling portion 410 may have a smaller cross section in the extension direction than the coupling member head 420.

At least a part of the stud coupling portion 410 may be accommodated in the stud inserting portion 330 of the stud 300.

The stud coupling portion 410 may penetrate the insertion hole 521H of the electronic equipment 500. The stud coupling portion 410 may penetrate the vibration reducing hole 531H of the vibration reducing member 530.

The stud coupling portion 410 may include a coupling member thread 411.

The coupling member thread 411 may have a shape corresponding to the female thread included in the stud inserting portion 330 of the stud 300.

The coupling member thread 411 may protrude outward in a radial direction along an extension direction of the stud coupling portion 410.

The coupling member thread 411 may protrude toward the stud inserting portion 330 of the stud 300.

The coupling member thread 411 may be positioned inside the stud inserting portion 330 of the stud 300.

The electronic equipment 500 may include the vibration reducing member 530.

The vibration reducing member 530 may have substantially a cylinder shape.

The vibration reducing member 530 may be detachably coupled with the hole forming portion 521.

At least a part of the vibration reducing member 530 may be positioned in the insertion hole 521H.

The vibration reducing member 530 may include a vibration damping portion 531.

The vibration damping portion 531 may have substantially a cylinder shape with a hole defined therein.

The vibration damping portion 531 may cover the stud inserting portion 330 of the stud 300.

The vibration damping portion 531 may extend from the stud supporting portion 320 of the stud 300 up to the coupling member head 420 of the coupling member 400.

The vibration damping portion 531 may penetrate the insertion hole 521H.

The vibration damping portion 531 may be positioned between the stud inserting portion 330 of the stud 300 and the hole forming portion 521. Therefore, vibration generated in the electronic equipment 500 may be prevented from being transferred to the stud 300 along the hole forming portion 521.

That is, the vibration damping portion 531 may be positioned between the hole forming portion 521 and the stud inserting portion 330.

The vibration damping portion 531 may extend from the stud supporting portion 320 to the coupling member head 420 to prevent friction sound generated between the coupling member 400 and the stud 300.

The vibration reducing member 530 may include a first hole supporting portion 532 and a second hole supporting portion 533.

The first hole supporting portion 532 may extend in a radial direction from the vibration damping portion 531 with respect to an extension direction of the vibration damping portion 531. The first hole supporting portion 532 may extend in a circumferential direction from the vibration damping portion 531 with respect to the extension direction of the vibration damping portion 531.

The first hole supporting portion 532 may have substantially a cylinder shape.

The first hole supporting portion 532 may be in contact with one side of the hole forming portion 521.

The second hole supporting portion 533 may have a shape corresponding to the first hole supporting portion 532.

The second hole supporting portion 533 may be positioned such that the hole forming portion 521 is located between the second hole supporting portion 533 and the first hole supporting portion 532. The second hole supporting portion 533 may be positioned to form an accommodating groove 533H between the second hole supporting portion 533 and the first hole supporting portion 532, wherein at least a part of the hole forming portion 521 is positioned in the accommodating groove 533H.

The second hole supporting portion 533 may be in contact with another side of the hole forming portion 521, which is opposite to the one side which the first hole supporting portion 532 is in contact with.

That is, the first hole supporting portion 532 may support one side of the hole forming portion 521.

The second hole supporting portion 533 may support another side of the hole forming portion 521, which is opposite to the one side of the hole forming portion 521.

The accommodating groove 533H may be positioned between the first hole supporting portion 532 and the second hole supporting portion 533 to accommodate the hole forming portion 521 therein.

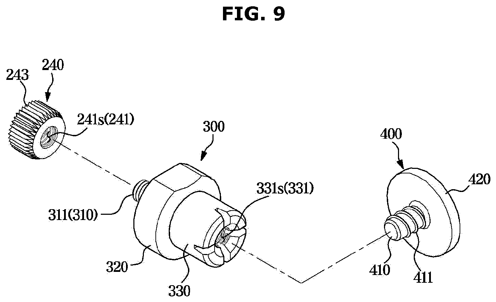

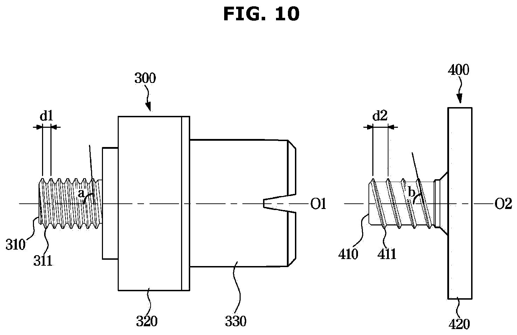

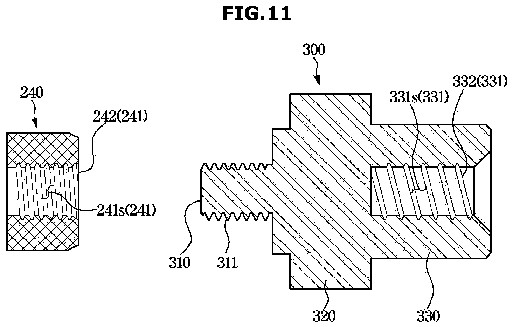

FIG. 9 is an exploded perspective view showing the stud nut 240, the stud 300, and the coupling member 400 shown in FIG. 8. FIG. 10 is a side view showing a coupled state of the stud 300 and the coupling member 400 shown in FIG. 9. FIG. 11 is an exploded cross-sectional view of the stud nut 240 and the stud 300 shown in FIG. 9.

A coupling relationship between the stud 300 and the coupling member 400 according to an embodiment of the present disclosure will be described with reference to FIGS. 9 to 11.

The stud nut 240 may include the nut protrusion 243.

The nut protrusion 243 may protrude radially outward from the stud nut 240.

A plurality of nut protrusions 243 may be provided. A friction force of the above-mentioned resin layer 230 (see FIG. 8) may increase by the nut protrusion 243.

The stud nut 240 may include a nut accommodating portion 241.

The nut accommodating portion 241 may accommodate at least a part of the stud 300 inside the stud nut 240. The chassis coupling portion 310 of the stud 300 may be accommodated in the nut accommodating portion 241.

The nut accommodating portion 241 may have a nut space 241S.

The nut space 241S may be formed by penetrating the stud nut 240.

The nut accommodating portion 241 may include a nut accommodating portion thread 242.

The nut accommodating portion thread 242 may be concave in a direction that is away from the nut space 241S.

The nut accommodating portion thread 242 may be in contact with the stud thread 311 (see FIG. 8) of the stud 300. The nut accommodating portion thread 242 may be engaged with the stud thread 311 of the stud 300.

The stud 300 may include a stud accommodating portion 331.

The stud accommodating portion 331 may be provided inside the stud inserting portion 330.

The stud accommodating portion 331 may accommodate at least a part of the coupling member 400. The stud inserting portion 330 of the coupling member 400 may be accommodated in the stud accommodating portion 331.

The stud accommodating portion 331 may have a stud space 331S.

The stud space 331S may be concave from the stud inserting portion 330 toward one side. The stud space 331S may be concave toward the front direction of the stud inserting portion 330.

The stud accommodating portion 331 may include a stud accommodating portion thread 332.

The stud accommodating portion thread 332 may be concave in a direction that is away from the stud space 331S.

The stud accommodating portion thread 332 may be in contact with the coupling member thread 411 (see FIG. 8) of the coupling member 400. The stud accommodating portion thread 332 may be engaged with the coupling member thread 411 of the coupling member 400.

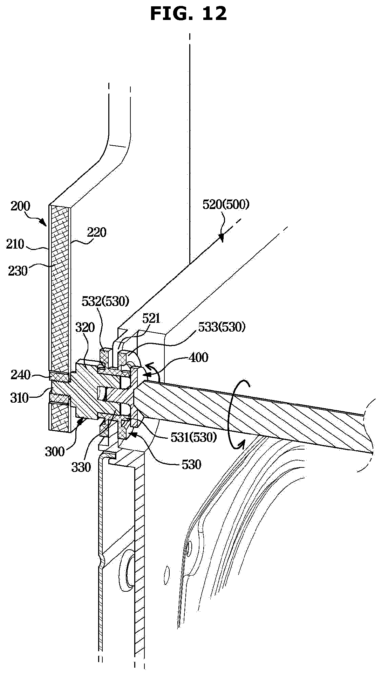

The coupling member 400 may need to be separated from the stud 300, as shown in FIGS. 12 to 23. In the case of replacing the electronic equipment 500 for service, the coupling member 400 may need to be separated from the stud 300 to separate the electronic equipment 500.

While the coupling member 400 is separated from the stud 300, the coupling member 400 may need to be easily separated from the stud 300 while preventing the stud 300 from being decoupled from the rear chassis 200 (see FIG. 8). Otherwise, the stud 300 may be first separated from the rear chassis 200. In this case, several processes of separating the stud 300 from the rear chassis 200, separating the coupling member 400 from the stud 300, and then installing the stud 300 on the rear chassis 200 may be required.

To prevent this, a coupling force between the coupling member 400 and the stud 300 may need to be weaker than a coupling force between the stud 300 and the rear chassis 200.

A case in which the coupling member 400 is screw-coupled with the stud 300 will be assumed and described.

The coupling member thread 411 of the coupling member 400 may have a greater pitch than the stud thread 311 of the stud 300. Here, a pitch may mean a height that increases when a thread is turned once.

In the case in which a pitch of the coupling member thread 411 is greater than a pitch of the stud thread 311, a contact area to the female thread engaged with the coupling member thread 411may be reduced. Therefore, a friction force applied to the coupling member thread 411 may be less than a friction force applied to the stud thread 311. That is, while a force is applied to the coupling member 400 to separate the coupling member 400 from the stud 300, coupling of the coupling member 400 and the stud 300 may be released with a smaller force than that required to separate the stud 300 from the rear chassis 200.

An angle of the coupling member thread 411 with respect to an extension direction OS of the stud coupling portion 410 of the coupling member 400 may be greater than an angle of the stud thread 311 with respect to an extension direction O1 of the chassis coupling portion 310. Therefore, a torque applied to the coupling member 400 to decouple the coupling member 400 from the stud 300 may increase a force that is effectively applied to the coupling member 400 in a direction of separating the coupling member 400 from the stud 300. That is, according to a torque being applied to the coupling member 400 to decouple the coupling member 400, a force effectively applied to the coupling member 400 by the torque for decoupling may be greater than a force applied to the stud 300 by the torque. That is, decoupling of the coupling member 400 from the stud 300 may be easier than decoupling of the stud 300 from the rear chassis 200.

However, the above-described characteristics about the pitch and angle of the coupling member thread 411 may be applied independently. Only the pitch of the coupling member thread 411 may be greater than that of the stud thread 311. Only the angle of the coupling member thread 411 with respect to the extension direction may be greater than that of the stud thread 311.

In other words, the coupling member thread 411 may have a greater pitch than the stud thread 311.

The angle of the coupling member thread 411 with respect to the extension direction of the coupling member 400 may be smaller than the angle of the stud thread 311 with respect to the extension direction of the stud 300.

The stud (300) contact area may be larger than the chassis contact area such that a friction force by the first coupling force is greater than a friction force by a chassis coupling force.

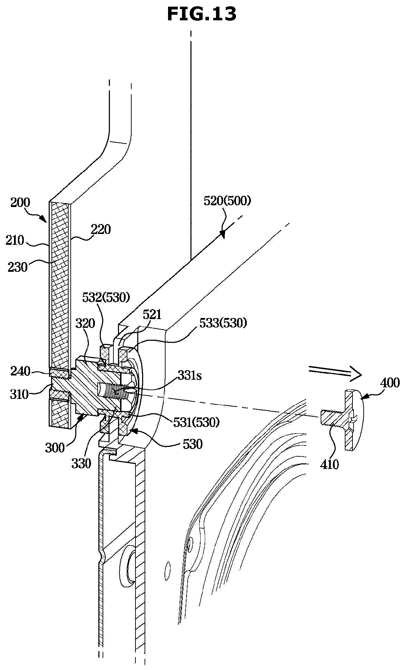

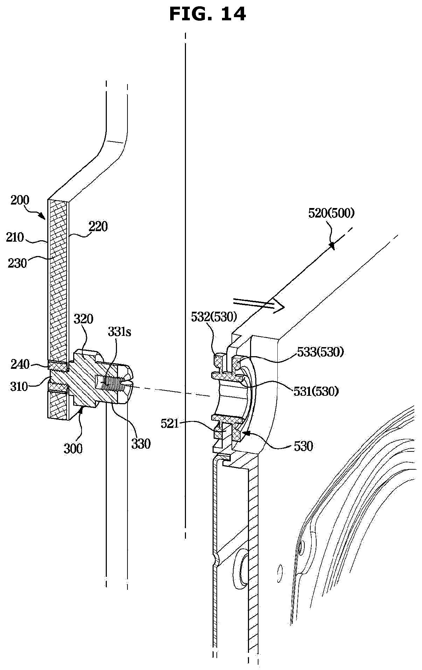

FIG. 12 is a cross-sectional perspective view showing decoupling of the coupling member 400 in the components related to the rear chassis 200 and the electronic equipment 500 shown in FIG. 7. FIG. 13 is a cross-sectional perspective view showing a decoupled state of the coupling member 400 shown in FIG. 12. FIG. 14 is a cross-sectional perspective view showing the electronic equipment 500 shown in FIG. 13, decoupled from the stud 300.

A process of separating the electronic equipment 500 from the rear chassis 200, according to an embodiment of the present disclosure, will be described with reference to FIGS. 12 to 14.

As shown in FIG. 12, a torque may be applied to the coupling member 400 by using a tool such as a driver.

While the torque is applied to the coupling member 400, the torque may be transferred to an area of the coupling member 400 coupled to the stud 300 and an area of the stud 300 coupled to the rear chassis 200. More specifically, the torque may be transferred to the coupling member thread 411 of the coupling member 400 and the stud thread 311 of the stud 300.

However, because a coupling force of the coupling member 400 with the stud 300 is weaker than a coupling force of the stud 300 with the rear chassis 200, coupling of the coupling member 400 and the stud 300 may be first released. While the coupling of the coupling member 400 and the stud 300 is first released, the coupling member thread 411 of the coupling member 400 may slide in the stud accommodating portion 331 of the stud 300, and a torque less than that required for the stud 300 to be decoupled from the rear chassis 200 may be applied to the stud thread 311. Therefore, in the state in which coupling of the stud 300 and the rear chassis 200 is not released, the coupling of the coupling member 400 and the stud 300 may be released.

The coupling member 400 may rotate in a direction of being decoupled from the stud 300 by the torque.

As shown in FIG. 13, the coupling member 400 may be decoupled from the stud 300.

While the coupling member 400 is decoupled from the stud 300, the electronic equipment 500 may not be prevented from moving backward.

As shown in FIG. 14, the electronic equipment 500 may be decoupled from the rear chassis 200.

The electronic equipment 500 may move backward.

In this case, the electronic equipment 500 may be replaced by new electronic equipment 500.

In other words, the coupling member 400 may move between a coupling position at which the coupling member 400 is coupled with the stud 300 and a separation position at which the coupling member 400 is separated from the stud 300. According to the coupling member 400 being at the coupling position, the electronic equipment 500 may be mounted on the rear chassis 200. According to the coupling member 400 being at the separation position, the electronic equipment 500 may be detachable from the rear chassis 200.

That is, in the case in which a coupling force of the stud 300 with the rear chassis 200 is referred to as a first coupling force and a coupling force of the coupling member 400 with the stud 300 is referred to as a second coupling force, the second coupling force may be weaker than the first coupling force such that, while the coupling member 400 is separated from the stud 300 to release the electronic equipment 500 from the rear chassis 200, coupling of the stud 300 and the rear chassis 200 is maintained.

A method of coupling the electronic equipment 500 to the rear chassis 200 may be performed in a reverse order of the above-described method of separating the electronic equipment 500 from the rear chassis 200.

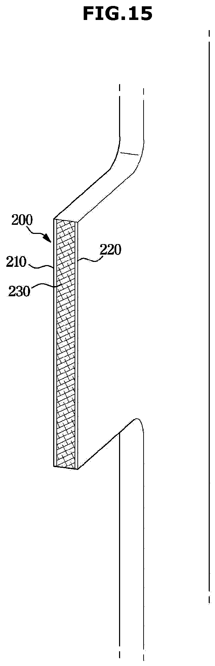

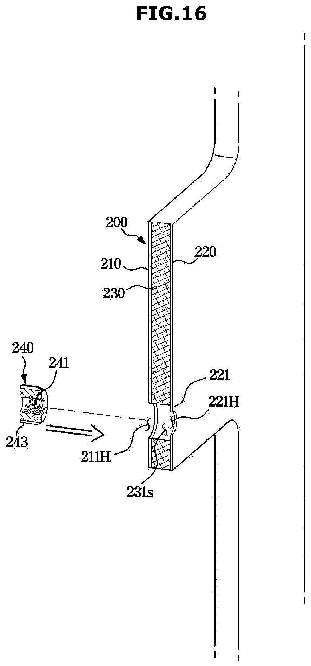

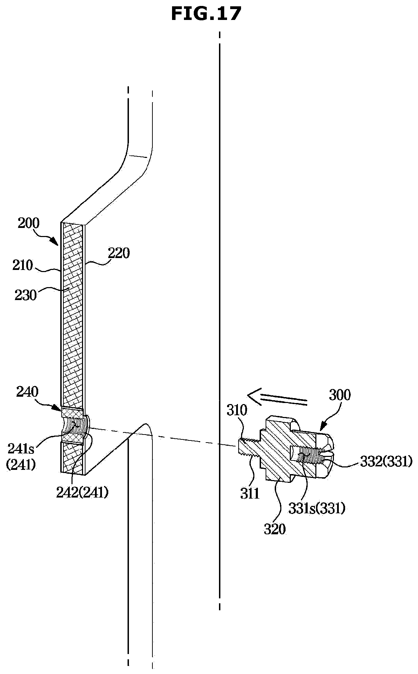

FIG. 15 is a cross-sectional perspective view showing a state of the rear chassis 200 shown in FIG. 5 before the stud nut 240 is coupled to the rear chassis 200. FIG. 16 is a cross-sectional perspective view showing a processed state of the rear chassis 200 shown in FIG. 15 to couple the stud nut 240 to the rear chassis 200. FIG. 17 is a cross-sectional perspective view showing a state in which the stud 300 is coupled to the stud nut 240 coupled to the rear chassis 200 shown in FIG. 16.

Coupling of the stud 300 and the rear chassis, according to an embodiment of the present disclosure, will be described with reference to FIGS. 15 to 17.

As shown in FIG. 15, the rear chassis 200 may include the resin layer 230 between the first metal layer 210 and the second metal layer 220.

While the stud 300 is inserted into the resin layer 230, the resin layer 230 may be deformed by a rotation of the stud 300. In this case, while a torque is applied to the coupling member 400, the coupling member 400 may not be decoupled from the stud 300 and the resin layer 230 may fail to support the torque applied to the stud 300, which may cause a rotation of the stud 300.

To prevent this, the following process may be performed.

As shown in FIG. 16, a nut accommodating space 231S may be formed by penetrating the resin layer 230 from the first metal layer 210.

The resin layer 230 may have the nut accommodating space 231S.

The nut accommodating space 231S may have a shape corresponding to the stud nut 240. The nut accommodating space 231S may have substantially a cylinder shape.

The stud nut 240 may be accommodated in the nut accommodating space 231S.

The first metal layer 210 may have a net penetration opening 211A through which the stud nut 240 passes. The nut penetration opening 211A may be positioned to correspond to the nut accommodating space 231S.

The second metal layer 220 may have a stud penetration hole 221H through which the chassis coupling portion 310 of the stud 300 passes.

The chassis coupling portion 310 may be inserted in the stud penetration hole 221H.

The second metal layer 220 may have a detachment preventing portion 221 that defines the stud penetration hole 221H.

The stud penetration hole 221H may have a smaller diameter than the stud nut 240. Therefore, the stud nut 240 may be prevented from passing through the stud penetration hole 221H.

The stud nut 240 may be prevented from departing from the second metal layer 220 by coming into contact with the detachment preventing portion 221.

That is, the detachment preventing portion 221 may be positioned between the stud nut 240 and the stud 300 to prevent the stud nut 240 from departing outward from the first metal layer 210.

The stud 300 may be coupled with the stud nut 240. The chassis coupling portion 310 of the stud 300 may be coupled with the nut accommodating portion 241 of the stud nut 240.

So far, the display device 1 according to an embodiment of the present disclosure has been described. Hereinafter, the display device 1 according to another embodiment will be described. In the following descriptions about an embodiment, the same components as those shown in FIGS. 1 to 17 will be assigned like reference numerals, and descriptions thereof will be omitted.

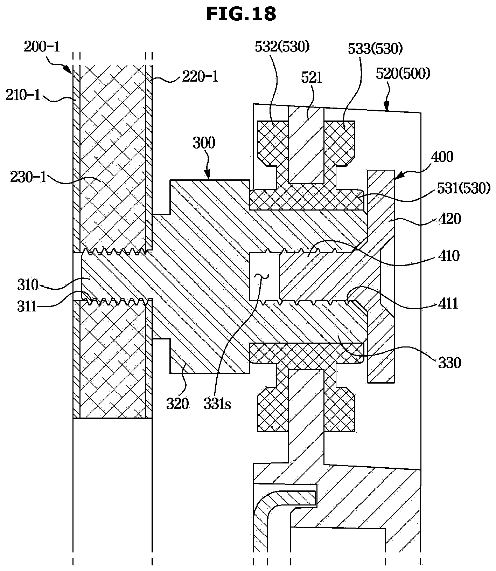

FIG. 18 is a cross-sectional view showing a part of a display device according to an embodiment of the present disclosure.

A rear chassis 200-1 according to an embodiment of the present disclosure will be described with reference to FIG. 18.

The rear chassis 200-1 may include a resin layer 230-1.

The resin layer 230-1 may be positioned between a first metal layer 210-1 and a second metal layer 220-1.

A chassis coupling portion 310 of a stud 300-1 may be accommodated in the resin layer 230-1.

In this case, the resin layer 230-1 may include a material having a rigidity sufficient to be not deformed by a torque applied to a coupling member 400-1.

The current embodiment may be different from an embodiment described with reference to FIGS. 1 to 17 in that the chassis coupling portion 310 of the stud 300-1 is directly inserted in the resin layer 230-1.

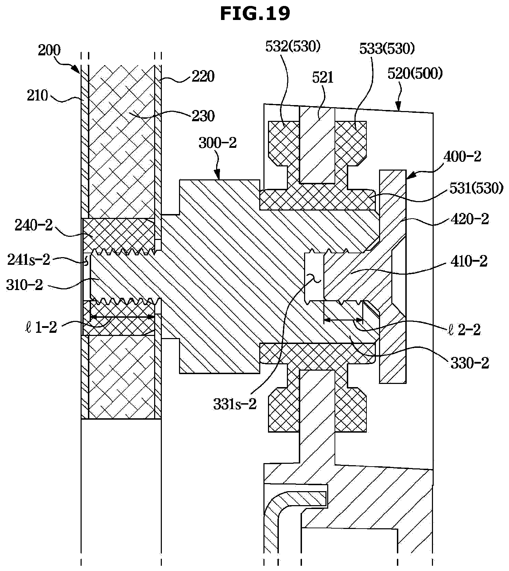

FIG. 19 is a cross-sectional view showing a part of the display device 1 according to an embodiment of the present disclosure.

A stud 300-2 and a coupling member 400-2 according to an embodiment of the present disclosure will be described with reference to FIG. 19.

The stud 300-2 may include a chassis coupling portion 310-2.

The chassis coupling portion 310-2 may be coupled to a rear chassis 200-2.

The coupling member 400-2 may include a stud inserting portion 330-2.

The stud inserting portion 330-2 may be coupled with the stud 300-2.

A length l-2 of the chassis coupling portion 310-2 may be longer than a length l-2 of the stud inserting portion 330-2. Therefore, a friction force between the chassis coupling portion 310-2 of the stud 300-2 and the rear chassis 200-2 may be greater than a friction force between the stud inserting portion 330-2 of the coupling member 400-2 and the stud 300-2. The reason may be because a friction area between the chassis coupling portion 310-2 of the stud 300-2 and the rear chassis 200-2 is larger than a friction area between the stud inserting portion 330-2 of the coupling member 400-2 and the stud 300-2.

Accordingly, by a force applied to the coupling member 400-2 to detach the coupling member 400-2 from the stud 300-2, coupling of the coupling member 400-2 and the stud 300-2 may be released before coupling of the stud 300-2 and the rear chassis 200 is released.

In other words, the chassis coupling portion 310-2 may extend along a chassis extension direction and the stud coupling portion 410-2 may extend along a stud (300-2) extension direction with a shorter length than the chassis coupling portion 310-2.

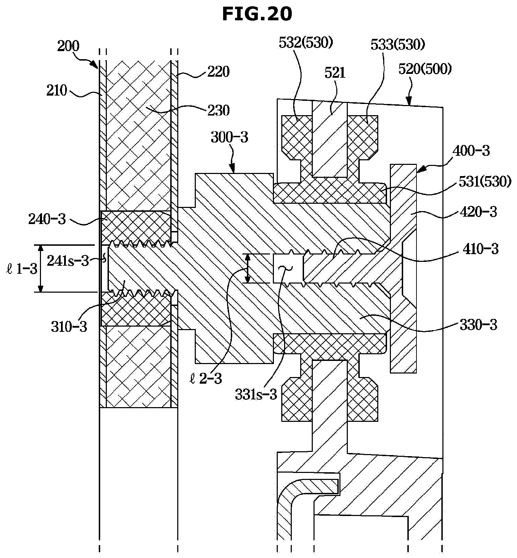

FIG. 20 is a cross-sectional view showing a part of the display device 1 according to an embodiment of the present disclosure.

A stud 300-3 and a coupling member 400-3 according to an embodiment of the present disclosure will be described with reference to FIG. 20.

The stud 300-3 may include a chassis coupling portion 310-3.

The chassis coupling portion 310-3 may be coupled to a rear chassis 200-3.

The coupling member 400-3 may include a stud inserting portion 330-3.

The stud inserting portion 330-3 may be coupled with the stud 300-3.

A thickness l-3 of the chassis coupling portion 310-2 may be greater than a thickness l-3 of the stud inserting portion 330-3. Therefore, a friction force between the chassis coupling portion 310-3 of the stud 300-3 and the rear chassis 200 may be greater than a friction force between the stud inserting portion 330-3 of the coupling member 400-3 and the stud 300-3. The reason may be because a friction area between the chassis coupling portion 310-3 of the stud 300-3 and the rear chassis 200 is larger than a friction area between the stud inserting portion 330-3 of the coupling member 400-3 and the stud 300-3.

Accordingly, by a force applied to the coupling member 400-3 to detach the coupling member 400-3 from the stud 300-3, coupling of the coupling member 400-3 and the stud 300-3 may be released before coupling of the stud 300-3 and the rear chassis 200-3 is released.

That is, a diameter of the stud coupling portion 410-3 may be smaller than a diameter of the chassis coupling portion 310-3.

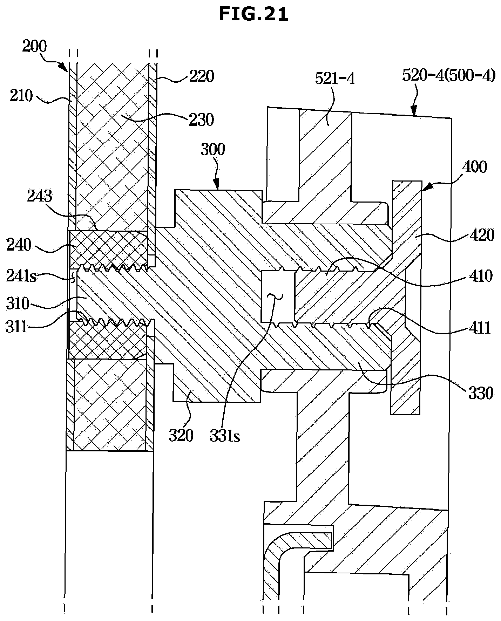

FIG. 21 is a cross-sectional view showing a part of the display device 1 according to an embodiment of the present disclosure.

Electronic equipment 500-4 according to an embodiment of the present disclosure will be described with reference to FIG. 21.

The electronic equipment 500-4 may include an insertion hole 521H-4.

The electronic equipment 500-4 may include a hole forming portion 521-4.

The hole forming portion 521-4 may define the insertion hole 521H-4.

The insertion hole 521H-4 may be defined to correspond to the stud inserting portion 330 of the stud 300.

The stud inserting portion 330 of the stud 300 may face the hole forming portion 521-4.

A portion of the hole forming portion 521-4, facing the stud inserting portion 330-4 of the stud 300, may cover the stud inserting portion 330 of the stud 300. The hole forming portion 521-4 may extend to correspond to the stud inserting portion 330 of the stud 300.

The hole forming portion 521-4 may support the stud supporting portion 320 of the stud 300 and the coupling member head 420 of the coupling member 400.

The present embodiment may be different from the embodiment described with reference to FIGS. 1 to 17 in that the stud 300 is coupled to the electronic equipment 500-4 without the vibration reducing member 530.

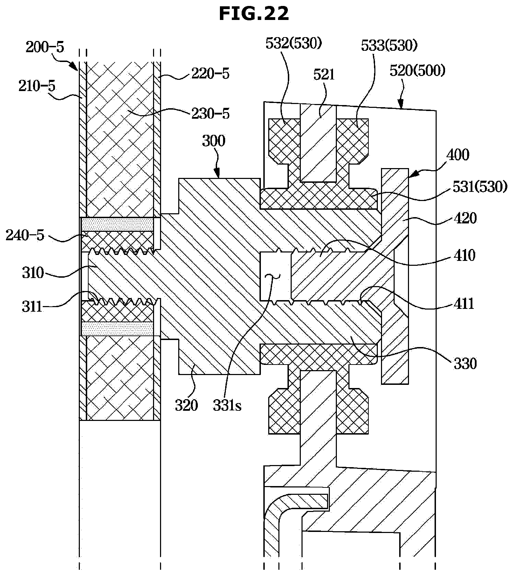

FIG. 22 is a cross-sectional view showing a part of the display device 1 according to an embodiment of the present disclosure.

Coupling of the stud 300 and a rear chassis 200-5 according to an embodiment of the present disclosure will be described with reference to FIG. 22.

The stud 300 may include the chassis coupling portion 310.

The chassis coupling portion 310 may be coupled to the rear chassis 200-5.

The rear chassis 200-5 may include an adhesive 250-5.

The adhesive 250-5 may be positioned between the chassis coupling portion 310 and a resin layer 230-5.

The chassis coupling portion 310 may be coupled to the resin layer 230-5 by the adhesive 250-5.

The chassis coupling portion 310 and the resin layer 230-5 may have a strong coupling force by the adhesive 250-5. Therefore, decoupling of the stud 300 from the rear chassis 200-5 by a force applied to the coupling member 400 may be prevented.

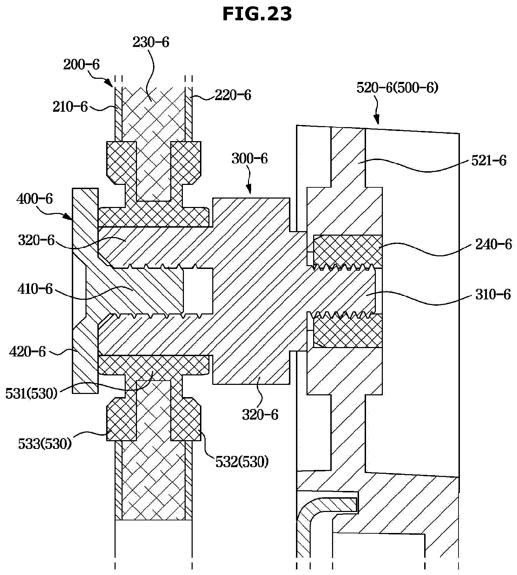

FIG. 23 is a cross-sectional view showing a part of the display device 1 according to an embodiment of the present disclosure.

Coupling of electronic equipment 500-6 and a rear chassis 200-6 according to an embodiment of the present disclosure will be described with reference to FIG. 23.

The electronic equipment 500-6 may include a stud nut 240-6.

A stud 300-6 may be coupled to the electronic equipment 500-6. A chassis coupling portion 310-6 of the stud 300-6 may be coupled to the electronic equipment 500-6. The chassis coupling portion 310-6 may be coupled with the stud nut 240-6.

The stud 300-6 may protrude to penetrate the rear chassis 200-6.

The rear chassis 200-6 may include a vibration reducing member 530-6.

The stud 300-6 may protrude to penetrate the vibration reducing member 530-6.

A coupling member head 420-6 may be coupled with the stud 300-6 in a direction from a first metal layer 210-6 toward a second metal layer 220-6.

The current embodiment may be different from an embodiment described with reference to FIGS. 1 to 17 in that the stud 300-6 protrudes to penetrate the rear chassis 200-6 from the electronic equipment 500-6 and a coupling member 400-6 is coupled with the stud 300-6 in another direction.

An embodiment according to a concept of the present disclosure may be as follows.

A display device 1 according to an embodiment of the present disclosure may include a display panel 100, a rear chassis 200 supporting the display panel 100, electronic equipment 500 being adjacent to the rear chassis 200 and including an insertion hole 521H, a stud 300 coupled to the rear chassis 200 with a first coupling force to protrude from the rear chassis 200, and a coupling member 400 coupled to the stud 300 with a second coupling force by penetrating the insertion hole 521H of the electronic equipment 500 to install the electronic equipment 500 on the rear chassis 200, the coupling member 400 being decouplable from the stud 300 and including a coupling member head 420 having a greater diameter than the insertion hole 521H, wherein the second coupling force may be weaker than the first coupling force such that, while the electronic equipment 500 is decoupled from the rear chassis 200 by separating the coupling member 400 from the stud 300, coupling of the stud 300 and the rear chassis 200 is maintained.

The stud 300 may include a chassis coupling portion 310 inserted in the rear chassis 200 and having a stud thread 311, the coupling member 400 may include a stud coupling portion 410 having a coupling member thread 411 capable of being inserted into the stud 300, and the coupling member thread 411 may have a greater pitch than the stud thread 311.

The stud 300 may include a chassis coupling portion 310 inserted into the rear chassis 200 along an extension direction of the stud 300 and including the stud thread 311, the coupling member 400 may include a stud coupling portion 410 having a coupling member thread 411 capable of being inserted into the stud 300 along an extension direction of the coupling member 400, and an angle of the coupling member thread 411 with respect to the extension direction of the coupling member 400 may be smaller than an angle of the stud thread 311 with respect to the extension direction of the stud 300.

The stud 300 may include a chassis coupling portion 310 inserted into the rear chassis 200 by coming in contact with the rear chassis 200 by a chassis contact area, the coupling member 400 may include a stud coupling portion 410 inserted into the stud 300 by coming in contact with the stud 300 by a stud 300 contact area, and the stud 300 contact area may be larger than the chassis contact area such that a friction force by the first coupling force is greater than a friction force by the chassis coupling force.

The chassis coupling portion 310 may extend along a chassis extension direction, and the stud coupling portion 410 may extend along the extension direction of the stud 300 with a shorter length than the chassis coupling portion 310.

A diameter of the stud coupling portion 410 may be smaller than a diameter of the chassis coupling portion 310.

The electronic equipment 500 may be capable of generating vibration, and the stud 300 may include a stud supporting portion 320 positioned between the electronic equipment 500 and the rear chassis 200 and spacing the electronic equipment 500 from the rear chassis 200 to prevent vibration generated in the electronic equipment 500 from being transferred to the display panel 100.

The stud 300 may include a stud inserting portion 330 extending from the stud supporting portion 320 to be inserted into the insertion hole 521H, wherein the coupling member 400 may be coupled to the stud inserting portion 330, and the electronic equipment 500 may include a hole forming portion 521 defining the insertion hole 521H, and a vibration reducing member 530 configured to prevent vibration of the electronic equipment 500 from being transferred to the stud 300 and including a vibration damping portion 531 positioned between the hole forming portion 521 and the stud inserting portion 330.

The vibration damping portion 531 may extend from the stud supporting portion 320 up to the coupling member head 420 to prevent friction sound that may be generated between the coupling member 400 and the stud 300, and the vibration reducing member 530 may include a first hole supporting portion 532 supporting one side of the hole forming portion 521, a second hole supporting portion 533 supporting another side of the hole forming portion 521, which is opposite to the one side of the hole forming portion 521, and an accommodating groove 533H positioned between the first hole supporting portion 532 and the second hole supporting portion 533 to accommodate the hole forming portion 521.

The rear chassis 200 may include a first metal layer 210 positioned on a side facing the display panel 100, a second metal layer 220 positioned on a side facing the electronic equipment 500, and a resin layer 230 positioned between the first metal layer 210 and the second meal layer 220, having a lower density than the first metal layer 210 and the second metal layer 220, and being deformable, wherein the chassis coupling portion 310 is inserted into the resin layer 230.

The display panel 100 may include a plurality of display modules 101 positioned to be adjacent to each other and facing the first metal layer 210, and the first metal layer 210 may support the plurality of display modules 101 to prevent a step from being formed between the plurality of display modules 101.

The stud 300 may include a metal material, and the rear chassis 200 may include a stud nut 240 positioned in the resin layer 230 to prevent the chassis coupling portion 310 from being coupled to the resin layer 230, the stud nut 240 coupleable with the chassis coupling portion 310 and including a metal material.

The stud nut 240 may include a nut protrusion 243 protruding toward the resin layer 230 to enhance a friction force with the resin layer 230.

The second metal layer 220 may include a stud penetration hole 221H into which the chassis coupling portion 310 is inserted, and
a detachment preventing portion 221 defining the stud penetration hole 221H and positioned between the stud nut 240 and the stud 300 to prevent the stud nut 240 from departing outward from the first metal layer 210.

The display panel 100 may include a plurality of display modules 101 being adjacent to each other, and the display device 1 may include a gap prevention sheet 20 positioned between the plurality of display modules 101 and the rear chassis 200, wherein a thermal expansion coefficient of the gap prevention sheet 20 has a value that is closer to a thermal expansion coefficient of the plurality of display modules 101 than a thermal expansion coefficient of the rear chassis 200 to prevent formation of a gap between the plurality of display modules 101, and
a deformation prevention sheet 21 positioned between the gap prevention sheet 20 and the rear chassis 200, wherein a thermal expansion coefficient of the deformation prevention sheet 21 may be smaller than the thermal expansion coefficient of the gap prevention sheet 20 and the thermal expansion coefficient of the rear chassis 200 to prevent deformation of the rear chassis 200 from being transferred to the gap prevention sheet 20.

A display device 1 according to a concept of the present disclosure may include a display panel 100 including a plurality of display modules 101, a rear chassis 200 supporting the display panel 100, a gap prevention sheet 20 positioned between the plurality of display modules 101 and the rear chassis 200, wherein a thermal expansion coefficient of the gap prevention sheet 20 may have a value that is closer to a thermal expansion coefficient of the plurality of display modules 101 than a thermal expansion coefficient of the rear chassis 200 to prevent formation of a gap between the plurality of display modules 101, a deformation prevention sheet 21 positioned between the gap prevention sheet 20 and the rear chassis 200, wherein a thermal expansion coefficient of the deformation prevention sheet 21 may be smaller than the thermal expansion coefficient of the gap prevention sheet 20 and the thermal expansion coefficient of the rear chassis 200 to prevent deformation of the rear chassis 200 from being transferred to the gap prevention sheet 20, electronic equipment 500 being adjacent to the rear chassis 200 and including an insertion hole 521H, a stud 300 of which at least a part is positioned by penetrating the insertion hole 521H, the stud 300 including a chassis coupling portion 310 inserted in the rear chassis 200 and having a stud thread 311, and a coupling member 400 coupled to the stud 300 to install the electronic equipment 500 on the rear chassis 200, the coupling member 400 including a stud coupling portion 410 having a coupling member thread 411 capable of being inserted into the stud 300, wherein, while the stud coupling portion 410 is separated from the stud 300, coupling of the stud 300 and the rear chassis 200 may be maintained.

An angle of the coupling member thread 411 with respect to the extension direction of the coupling member 400 may be smaller than an angle of the stud thread 311 with respect to the extension direction of the stud 300.

The stud (300) contact area may be larger than the chassis contact area such that a friction force of the stud 300 with respect to the rear chassis 200 is greater than a friction force of the coupling member 400 with respect to the stud 300.

The electronic equipment 500 may generate vibration, and the stud 300 may include a stud supporting portion 320 positioned between the electronic equipment 500 and the rear chassis 200 and spacing the electronic equipment 500 from the rear chassis 200 to prevent vibration generated in the electronic equipment 500 from being transferred to the display panel 100.

A display device 1according to a concept of the present disclosure may include a display panel 100 including a plurality of display modules 101 being adjacent to each other, a rear chassis 200 supporting the display panel 100, the rear chassis 200 including a first metal layer 210 positioned toward the display panel 100, a second metal layer 220 being opposite to the first metal layer 210, and a resin layer 230 positioned between the first metal layer 210 and the second meal layer 220, electronic equipment 500 being adjacent to the rear chassis 200 and including an insertion hole 521H, a stud 300 coupled to the rear chassis 200 and positioned by penetrating the insertion hole 521H, and a coupling member 400 coupled to the stud 300, wherein the stud 300 may include a chassis coupling portion 310 inserted into the rear chassis 200 along an extension direction of the stud 300 and having a stud thread 311, the coupling member 400 may include a stud coupling portion 410 having a coupling member thread 411 capable of being inserted into the stud 300 along an extension direction of the coupling member 400, and an angle of the coupling member thread 411 with respect to the extension direction of the coupling member 400 may be smaller than an angle of the stud thread 311 with respect to the extension direction of the stud 300.

The above-described embodiments can be combined with other embodiments unless clearly indicated otherwise. Alternatively, the embodiments can be combined with each other unless there are obvious limitations. Combinations of any embodiment and the other embodiments are considered to be disclosed in the present document.

So far, specific embodiments have been shown and described. However, the present disclosure is not limited to the above-described embodiments, and various modifications can be made by one of ordinary skill in the technical art to which the present disclosure belongs without departing from the gist of the technical idea of the present disclosure defined by the claims below.

## Claims

1. A display device 1 comprising:
a display panel 100;
a rear chassis 200 supporting the display panel 100;
electronic equipment 500 being adjacent to the rear chassis 200 and including comprising an insertion hole 521H;
a stud 300 coupled to the rear chassis 200 with a first coupling force to protrude from the rear chassis 200; and
a coupling member 400 coupled to the stud 300 with a second coupling force by penetrating the insertion hole 521H of the electronic equipment 500 to install the electronic equipment 500 on the rear chassis 200, the coupling member 400 being decouplable from the stud 300 and comprising a coupling member head 420 having a greater diameter than the insertion hole 521H,
wherein the second coupling force is weaker than the first coupling force such that, while the electronic equipment 500 is decoupled from the rear chassis 200 by separating the coupling member 400 from the stud 300, coupling of the stud 300 and the rear chassis 200 is maintained.

2. The display device 1 of claim 1, wherein
the stud 300 comprises a chassis coupling portion 310 inserted in the rear chassis 200 and having a stud thread 311,
the coupling member 400 comprises a stud coupling portion 410 comprising a coupling member thread 411 capable of being inserted into the stud 300, and
the coupling member thread 411 has a greater pitch than the stud thread 311.

3. The display device 1 of claim 1, wherein
the stud 300 comprises a chassis coupling portion 310 inserted into the rear chassis 200 along an extension direction of the stud 300 and comprising the stud thread 311,
the coupling member 400 comprises a stud coupling portion 410 having a coupling member thread 411 capable of being inserted into the stud 300 along an extension direction of the coupling member 400, and
an angle of the coupling member thread 411 with respect to the extension direction of the coupling member 400 is smaller than an angle of the stud thread 311 with respect to the extension direction of the stud 300.

4. The display device 1 of claim 1, wherein
the stud 300 comprises a chassis coupling portion 310 inserted into the rear chassis 200 by coming in contact with the rear chassis 200 by a chassis contact area,
the coupling member 400 comprises a stud coupling portion 410 inserted into the stud 300 by coming in contact with the stud 300 by a stud 300 contact area, and
the stud 300 contact area is larger than the chassis contact area such that a friction force by the first coupling force is greater than a friction force by the chassis coupling force.

5. The display device 1 of claim 4, wherein
the chassis coupling portion 310 extends along a chassis extension direction, and
the stud coupling portion 410 extends along a stud 300 extension direction with a shorter length than the chassis coupling portion 310.

6. The display device 1 of claim 4, wherein
a diameter of the stud coupling portion 410 is smaller than a diameter of the chassis coupling portion 310.

7. The display device 1 of claim 1, wherein
the electronic equipment 500 capable of generating vibration, and
the stud 300 comprises a stud supporting portion 320 positioned between the electronic equipment 500 and the rear chassis 200 for spacing the electronic equipment 500 from the rear chassis 200 to prevent vibration generated in the electronic equipment 500 from being transferred to the display panel 100.

8. The display device 1 of claim 7, wherein
the stud 300 comprises a stud inserting portion 330 extending from the stud supporting portion 320 to be inserted into the insertion hole 521H, the stud inserting portion 330 to which the coupling member 400 is coupled, and
the electronic equipment 500 comprises:
a hole forming portion 521 defining the insertion hole 521H, and
a vibration reducing member 530 configured to prevent vibration of the electronic equipment 500 from being transferred to the stud 300 and comprising a vibration damping portion 531 positioned between the hole forming portion 521 and the stud inserting portion 330.

9. The display device 1 of claim 8, wherein
the vibration damping portion 531 extends from the stud supporting portion 320 up to the coupling member head 420 and is configured to prevent friction sound that is generated between the coupling member 400 and the stud 300, and
the vibration reducing member 530 comprises:
a first hole supporting portion 532 supporting one side of the hole forming portion 521;
a second hole supporting portion 533 supporting another side of the hole forming portion 521, which is opposite to the one side of the hole forming portion 521; and
an accommodating groove 533H positioned between the first hole supporting portion 532 and the second hole supporting portion 533 to accommodate the hole forming portion 521.

10. The display device 1 of claim 2, wherein
the rear chassis 200 comprises:
a first metal layer 210 positioned on a side facing the display panel 100;
a second metal layer 220 positioned on a side facing the electronic equipment 500; and
a resin layer 230 positioned between the first metal layer 210 and the second metal layer 220, having a lower density than the first metal layer 210 and the second metal layer 220, and being deformable, the resin layer 230 into which the chassis coupling portion 310 is inserted.

11. The display device 1 of claim 10, wherein
the display panel 100 comprises a plurality of display modules 101 positioned to be adjacent to each other and facing the first metal layer 210, and
the first metal layer 210 supports the plurality of display modules 101 to prevent a step from being formed between the plurality of display modules 101.

12. The display device 1 of claim 10, wherein
the stud 300 comprises a metal material, and
the rear chassis 200 comprises a stud nut 240 positioned in the resin layer 230 to prevent the chassis coupling portion 310 from being coupled to the resin layer 230, the stud nut 240 coupleable with the chassis coupling portion 310 and comprising a metal material.

13. The display device 1 of claim 12, wherein
the stud nut 240 comprises a nut protrusion 243 protruding toward the resin layer 230 to enhance a friction force with the resin layer 230.

14. The display device 1 of claim 12, wherein
the second metal layer 220 comprises:
a stud penetration hole 221H into which the chassis coupling portion 310 is inserted; and
a detachment preventing portion 221 defining the stud penetration hole 221H and positioned between the stud nut 240 and the stud 300 to prevent the stud nut 240 from departing outward from the first metal layer 210.

15. The display device 1 of claim 1, wherein
the display panel 100 comprises a plurality of display modules 101 being adjacent to each other,
the display device 1 comprises
a gap prevention sheet 20 positioned between the plurality of display modules 101 and the rear chassis 200, the gap prevention sheet 20 having a thermal expansion coefficient which has a value that is closer to a thermal expansion coefficient of the plurality of display modules 101 than a thermal expansion coefficient of the rear chassis 200 to prevent formation of a gap between the plurality of display modules 101; and
a deformation prevention sheet 21 positioned between the gap prevention sheet 20 and the rear chassis 200, the deformation prevention sheet 21 having a thermal expansion coefficient that is smaller than the thermal expansion coefficient of the gap prevention sheet 20 and the thermal expansion coefficient of the rear chassis 200 to prevent deformation of the rear chassis 200 from being transferred to the gap prevention sheet 20.
